(19) Europäisches Patentamt
European Patent Office
Office européen des brevets

(11) **EP 4 331 816 A1**

(12) **EUROPEAN PATENT APPLICATION**
published in accordance with Art. 153(4) EPC

(43) Date of publication:
06.03.2024 Bulletin 2024/10

(21) Application number: 22795422.9

(22) Date of filing: 25.03.2022

(51) International Patent Classification (IPC):
*B29C 69/00* (2006.01)    *B65H 41/00* (2006.01)
*H01L 21/02* (2006.01)    *H01L 21/683* (2006.01)
*H01L 21/301* (2006.01)

(52) Cooperative Patent Classification (CPC):
B29C 69/00; B65H 41/00; H01L 21/02;
H01L 21/30; H01L 21/683

(86) International application number:
PCT/JP2022/014586

(87) International publication number:
WO 2022/230505 (03.11.2022 Gazette 2022/44)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 28.04.2021  JP 2021076402
14.05.2021  JP 2021082330

(71) Applicant: TOYOBO CO., LTD.
Osaka-shi, Osaka 530-0001 (JP)

(72) Inventors:
• OKUYAMA, Tetsuo
Otsu-shi, Shiga 520-0292 (JP)
• TSURUNO, Yoshihiro
Otsu-shi, Shiga 520-0292 (JP)

(74) Representative: Vossius & Partner
Patentanwälte Rechtsanwälte mbB
Siebertstraße 3
81675 München (DE)

(54) **POLYMER FILM RELEASING METHOD, METHOD FOR MANUFACTURING ELECTRONIC DEVICE, AND RELEASING DEVICE**

(57)     Provided is a releasing method that, without affecting the quality of an electronic device formed on a surface of a polymer film, can easily release the polymer film from an inorganic substrate. Provided is a method for releasing a first polymer film, characterized by including: a step A in which a layered body is prepared by adhering, to each other, an inorganic substrate and a first polymer film on which an electronic device has been formed; a step B1 in which the first polymer film side of the layered body is placed and fixed so as to be in contact with a vacuum suction plate, a partition wall is provided on a side surface of the layered body, and a second polymer film that is larger than the inorganic substrate is layered onto the inorganic substrate side of the layered body, so as to provide an enclosed space formed by the vacuum suction plate, the second polymer film, and the partition wall; and a step C in which a releasing portion is provided between the first polymer film and the inorganic substrate of the layered body and air is injected into this releasing portion to release the first polymer film while keeping same approximately level.

Fig.12

**Description**

TECHNICAL FIELD

The present invention relates to a polymer film releasing method, a method for manufacturing an electronic device, and a releasing device.

BACKGROUND ART

In recent years, for the purpose of weight reduction, size reduction, thickness reduction, and flexibility of functional elements such as semiconductor elements, MEMS elements, display elements, and sensor elements, or for the purpose of finely producing heaters, multilayer circuit boards, and wiring portions for semiconductors or producing these elements on heat-resistant films, technologies for forming these elements on polymer films have been actively developed. In other words, as materials for substrates of electronic parts such as information and communication equipment (broadcasting equipment, mobile radio, portable communication equipment, and the like), radar, and highspeed information processing equipment, ceramics which exhibit heat resistance and can cope with increases in frequencies (reaching the GHz band) of the signal band of information and communication equipment have been conventionally used. However, ceramics are not flexible and are also hardly thinned and thus have a drawback that the applicable fields are limited, and polymer films have recently been used as substrates.

When functional elements such as semiconductor elements, MEMS elements, display elements, and display elements, heaters, multilayer circuit boards, or wiring portions for semiconductors are formed on the surface of polymer films, it is ideal to perform processing by a so-called roll-to-roll process which utilizes the flexibility that is a property of polymer films. However, in industries such as semiconductor industry, MEMS industry, display industry, and sensor element industry, process technologies for rigid flat substrates such as wafer bases or glass substrate bases have been so far constructed. Hence, in order to form functional elements on polymer films utilizing the existing infrastructure, a process is used in which the polymer films are bonded to, for example, rigid supports made of inorganic substances such as glass plates, ceramic plates, silicon wafers, and metal plates, desired elements are formed on the laminates, and then the polymer films and desired elements are released from the supports.

Conventionally, as a method of releasing a polymer film from a support, a method of weakening adhesion force between a polymer film and a support by irradiation with laser light and releasing the polymer film from the support is known (see, for example, Patent Document 1). Various methods of facilitating laser peeling have been studied (see, for example, Patent Document 2).

A method of mechanically releasing a film has also been studied (see, for example, Patent Document 3).

PRIOR ART DOCUMENTS

PATENT DOCUMENTS

Patent Document 1: JP-A-10-125931
Patent Document 2: JP-A-2018-199163
Patent Document 3: JP-A-2015-38001

SUMMARY OF THE INVENTION

PROBLEMS TO BE SOLVED BY THE INVENTION

However, in the method of Patent Document 1, since the entire surface of the support is irradiated with laser light, there is a problem in that a large-scale irradiation device for irradiation of laser light is required. Since the polymer film is irradiated with laser light, there is a problem in that the polymer film is, for example, burnt and this affects the quality of the polymer film. There is a concern that a circuit or device formed on a surface of the polymer film and an element mounted on the polymer film are irradiated with laser light leaked, or shock waves are generated by laser heating, thereby affecting quality.

Mechanical releasing has also been concerned to cause damage to the polymer film itself due to stress and to affect the quality of a circuit or device formed on a surface of the polymer film and an element mounted on the polymer film, along with deformation of the polymer film. In the method of Patent Document 2, a step of forming a layer for facilitating releasing between a support and a polyimide film in advance is required, which is complicated. Since the method of Patent Document 3 is a mechanical method, it is still difficult to prevent defects from occurring in a device at times.

The present invention has been made in view of the above problems, and an object thereof is to provide a polymer film releasing method, a method for manufacturing an electronic device, and a releasing device that can easily release a polymer film from an inorganic substrate without affecting the qualities of a polymer film, a circuit or device formed on a surface of the polymer film, and an element mounted on the polymer film.

MEANS FOR SOLVING THE PROBLEMS

The present inventors have conducted intensive studies on a polymer film releasing method, a method for manufacturing an electronic device, and a releasing device. As a result, the present inventors have found that, by adopting the following configuration, it is possible to easily release a polymer film from an inorganic substrate without affecting the qualities of a polymer film, a circuit or device formed on a surface of the polymer film, and an element mounted on the polymer film, and have completed the present invention.

In other words, the present invention provides the following.

[1] A first polymer film releasing method including:

a step A of preparing a laminated body in which a first polymer film on which an electronic device is formed and an inorganic substrate are in close contact with each other;
a step B1 of fixing the laminated body to a vacuum adsorption plate such that a surface of the first polymer film of the laminated body is installed to be in contact with the vacuum adsorption plate, providing a partition wall on a side surface of the laminated body, and laminating a second polymer film, which is larger than the inorganic substrate, on a surface of the inorganic substrate of the laminated body to provide a sealed space formed by the vacuum adsorption plate, the second polymer film, and the partition wall; and
a step C of providing a releasing portion between the first polymer film and the inorganic substrate of the laminated body and injecting a gas into the releasing portion to release the first polymer film while keeping the first polymer film substantially flat.

[2] A first polymer film releasing method including:

a step A of preparing a laminated body in which a first polymer film on which an electronic device is formed and an inorganic substrate are in close contact with each other;
a step B2 of laminating a third polymer film, which is larger than the first polymer film, on a surface of the first polymer film of the laminated body, fixing the laminated body to a vacuum adsorption plate such that the third polymer film is installed to be in contact with the vacuum adsorption plate, providing a partition wall on a side surface of the laminated body, and laminating a second polymer film, which is larger than the inorganic substrate, on a surface of the inorganic substrate of the laminated body to provide a sealed space formed by the second polymer film, the third polymer film, and the partition wall; and
a step C of providing a releasing portion between the first polymer film and the inorganic substrate of the laminated body and injecting a gas into the releasing portion to release the first polymer film while keeping the first polymer film substantially flat.

[3] The first polymer film releasing method according to [1] or [2], wherein in the step C, a pressure inside the sealed space is increased to be higher by 0.02 atm or more than a pressure outside the sealed space by injecting a gas into the releasing portion.
[4] The first polymer film releasing method according to any one of [1] to [3], wherein an adhesive protective film is laminated on a surface of the vacuum adsorption plate.
[5] The first polymer film releasing method according to [4], wherein the fixing of the laminated body to the vacuum adsorption plate is vacuum adsorption or adhesion, or both vacuum adsorption and adhesion.
[6] The first polymer film releasing method according to any one of [1] to [5], wherein the electronic device is a functional element having a thickness of 10 um or more and 3 mm or less.
[7] The first polymer film releasing method according to any one of [1] to [6], wherein an embedding vacuum chuck and/or a spacer having a shape obtained by inverting a shape of the functional element is disposed on a side of the first polymer film opposite to the inorganic substrate before the step C.
[8] The first polymer film releasing method according to any one of [1] to [7], wherein a restriction plate, which restricts deformation of the inorganic substrate, is installed on a side of the second polymer film opposite to the inorganic substrate, and a distance between the restriction plate and the second polymer film is 0.5 mm or more and 5 mm or less.

[9] The first polymer film releasing method according to any one of [1] to [7], wherein a restriction plate, which restricts deformation of the inorganic substrate, is installed on a side of the second polymer film opposite to the inorganic substrate, and the restriction plate and the second polymer film are in contact with each other.

[10] The first polymer film releasing method according to any one of [1] to [9], wherein a peeling strength F2 between the inorganic substrate and the second polymer film and a peeling strength F1 between the inorganic substrate and the first polymer film have the following relationship:

$$2 \times F1 < F2.$$

[11] The first polymer film releasing method according to any one of [2] to [9], wherein a peeling strength F2 between the inorganic substrate and the second polymer film, a peeling strength F3 between the first polymer film and the third polymer film, and a peeling strength F1 between the inorganic substrate and the first polymer film have the following relationship:

$$2 \times F1 < F2 \text{ and } 2 \times F1 < F3.$$

[12] A method for manufacturing a polymer film equipped with an electronic device, including:

a step A of preparing a laminated body in which a first polymer film on which an electronic device is formed and an inorganic substrate are in close contact with each other;
a step B1 of fixing the laminated body to a vacuum adsorption plate such that a surface of the first polymer film of the laminated body is installed to be in contact with the vacuum adsorption plate, providing a partition wall on a side surface of the laminated body, and laminating a second polymer film, which is larger than the inorganic substrate, on a surface of the inorganic substrate of the laminated body to provide a sealed space formed by the vacuum adsorption plate, the second polymer film, and the partition wall; and
a step C of injecting a gas between the first polymer film and the inorganic substrate of the laminated body to release the first polymer film while keeping the first polymer film substantially flat.

[13] A method for manufacturing a polymer film equipped with an electronic device, including:

a step A of preparing a laminated body in which a first polymer film on which an electronic device is formed and an inorganic substrate are in close contact with each other;
a step B2 of laminating a third polymer film, which is larger than the first polymer film, on a surface of the first polymer film of the laminated body, fixing the laminated body to a vacuum adsorption plate such that the third polymer film is installed to be in contact with the vacuum adsorption plate, providing a partition wall on a side surface of the laminated body, and laminating a second polymer film, which is larger than the inorganic substrate, on a surface of the inorganic substrate of the laminated body to provide a sealed space formed by the second polymer film, the third polymer film, and the partition wall; and
a step C of injecting a gas between the first polymer film and the inorganic substrate of the laminated body to release the first polymer film while keeping the first polymer film substantially flat.

[14] A releasing device of peeling off a first polymer film from an inorganic substrate of a laminated body in which the first polymer film on which an electronic device is formed and the inorganic substrate are in close contact with each other, the releasing device including:

a pressure applying means for providing a pressure to a releasing portion between the first polymer film and the inorganic substrate, the releasing portion being provided at an end of the laminated body;
a means for installing a vacuum adsorption plate on a surface of the first polymer film of the laminated body, installing a partition wall on a side surface of the laminated body, and installing a second polymer film, which is larger than the inorganic substrate, on a surface of the inorganic substrate to provide a sealed space; and
a means for fixing the first polymer film substantially flatly during peeling.

[15] A releasing device of peeling off a first polymer film from an inorganic substrate of a laminated body in which the first polymer film on which an electronic device is formed and the inorganic substrate are in close contact with each other, the releasing device including:

a pressure applying means for providing a pressure to a releasing portion between the first polymer film and the inorganic substrate, the releasing portion being provided at an end of the laminated body;

a means for installing a third polymer film, which is larger than the first polymer film, on a surface of the first polymer film of the laminated body, installing a partition wall on a side surface of the laminated body, and installing a second polymer film, which is larger than the inorganic substrate, on a surface of the inorganic substrate to provide a sealed space; and

a means for fixing the first polymer film substantially flatly during peeling.

According to the above configuration, since the polymer film is released from the inorganic substrate by injecting a gas into the releasing portion and applying a pressure instead of mechanical peeling and the polymer film is released without being bent (substantially flatly), the polymer film can be easily released from the inorganic substrate without affecting the quality of the polymer film.

EFFECT OF THE INVENTION

According to the present invention, it is possible to easily release a polymer film from an inorganic substrate without affecting the quality of the polymer film and the quality of an electronic device including a wiring or thin film device formed on a surface of the polymer film and a functional element mounted on the polymer film.

BRIEF DESCRIPTION OF THE DRAWINGS

Fig. 1 is a schematic cross-sectional view illustrating an example of a laminated body.

Fig. 2-1(1) is a schematic cross-sectional view of a releasing device according to a first embodiment. Fig. 2-1(1) shows a state where the releasing device is in the middle of being set and a second polymer film is installed on a partition wall.

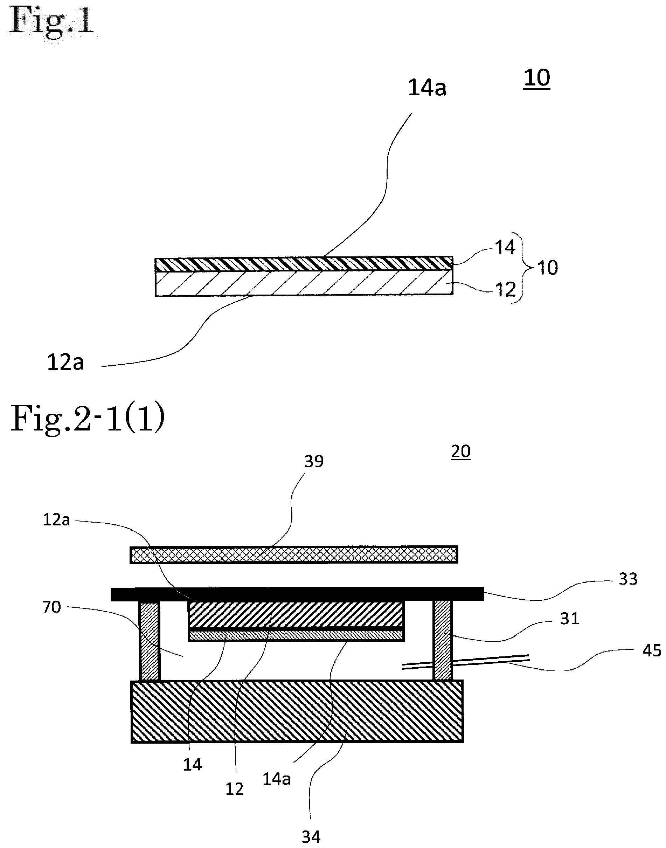

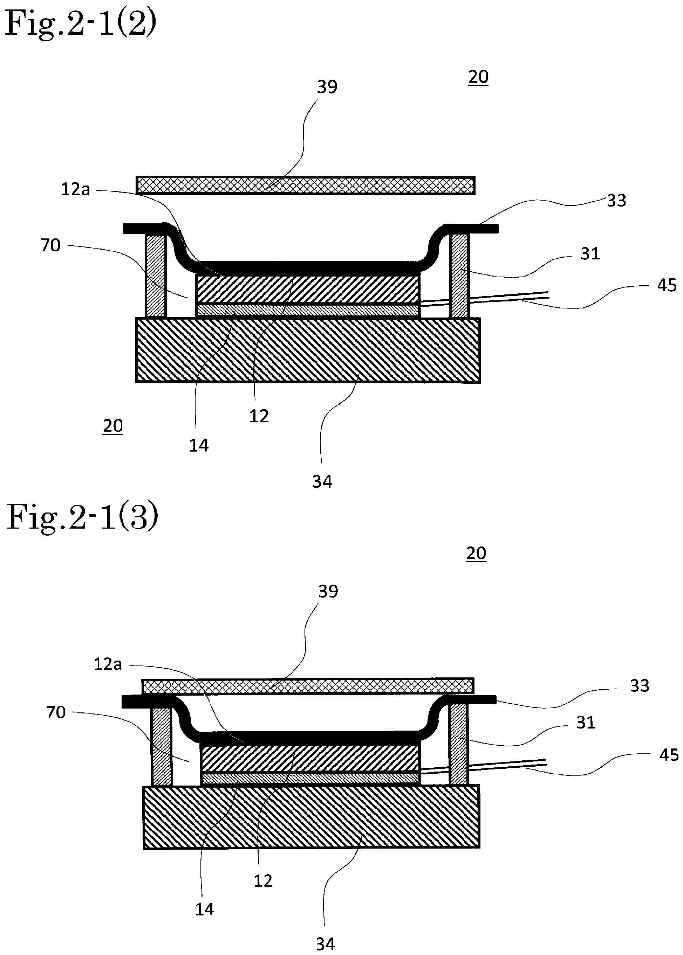

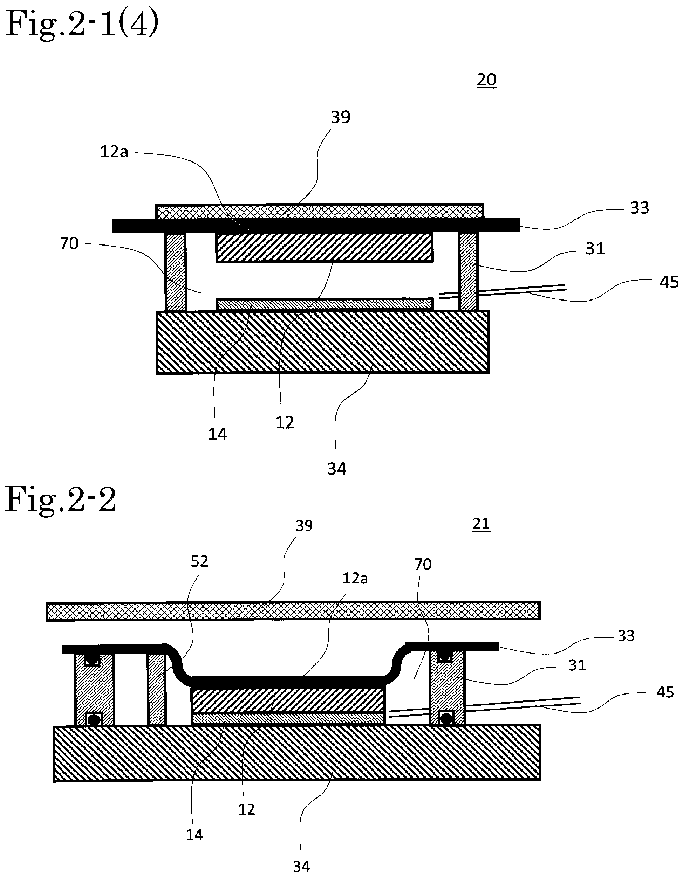

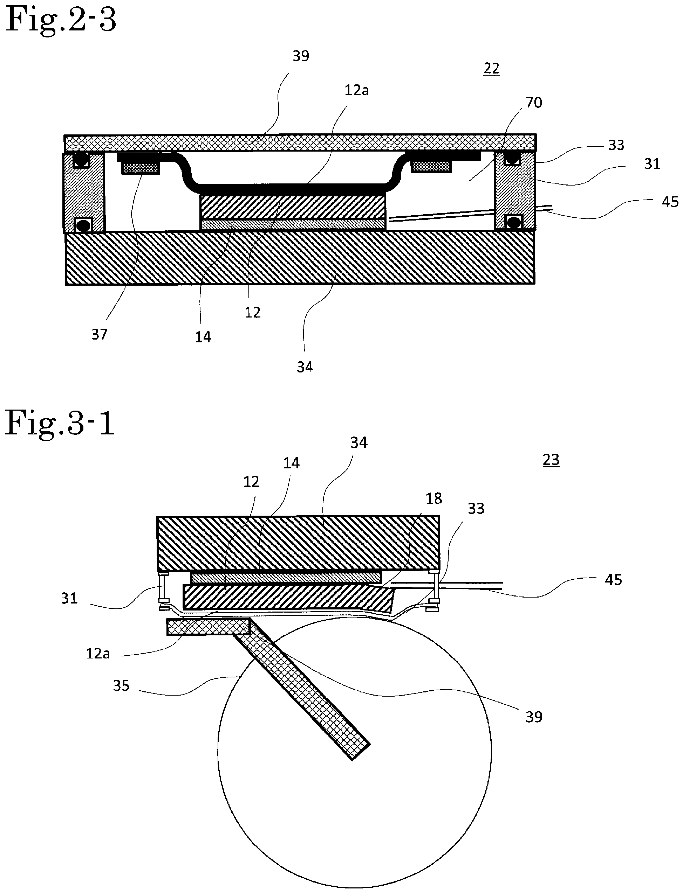

Fig. 2-1(2) is a schematic cross-sectional view of the releasing device according to the first embodiment. Fig. 2-1(2) shows a state where the releasing device is in the middle of being set and a laminated body is fixed to a vacuum adsorption plate.

Fig. 2-1(3) is a schematic cross-sectional view of the releasing device according to the first embodiment. Fig. 2-1(3) shows a state where setting is completed.

Fig. 2-1(4) is a schematic cross-sectional view of the releasing device according to the first embodiment. Fig. 2-1(4) shows a state where releasing is completed.

Fig. 2-2 is a schematic cross-sectional view of a releasing device different from the releasing device of Fig. 2-1 according to the first embodiment. Fig. 2-2 shows a state where the releasing device is in the middle of being set.

Fig. 2-3 is a schematic cross-sectional view of a releasing device different from the releasing devices of Figs. 2-1 and 2-2 according to the first embodiment, immediately before a releasing operation.

Fig. 3-1 is a schematic cross-sectional view of a releasing device according to a second embodiment. Fig. 3-1 is a schematic cross-sectional view of the releasing device immediately before releasing.

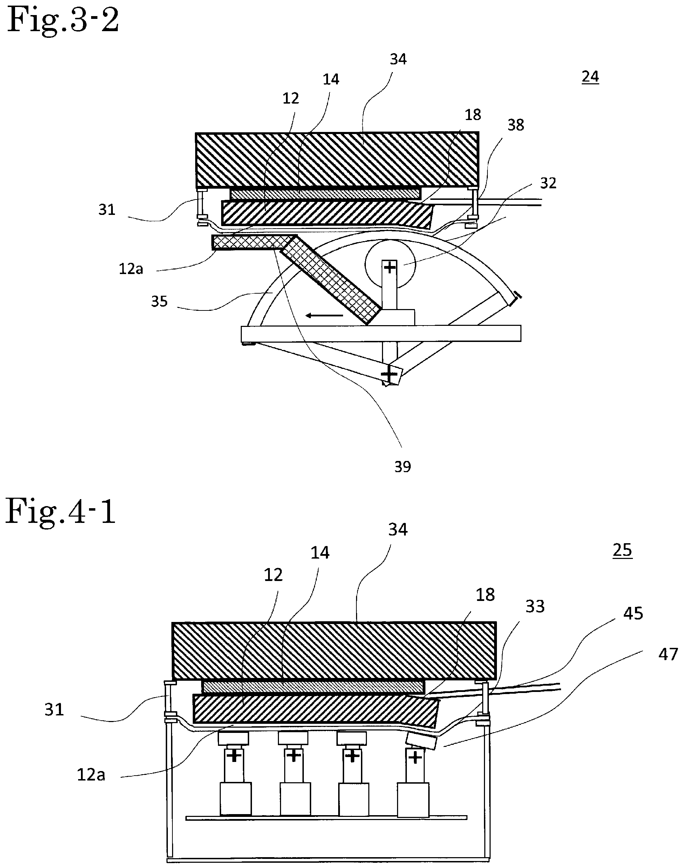

Fig. 3-2 is a schematic cross-sectional view of a releasing device different from the releasing device of Fig. 3-1 according to the second embodiment. Fig. 3-2 is a schematic cross-sectional view of the releasing device immediately before releasing.

Fig. 4-1 is a schematic cross-sectional view of a releasing device according to a third embodiment immediately before releasing.

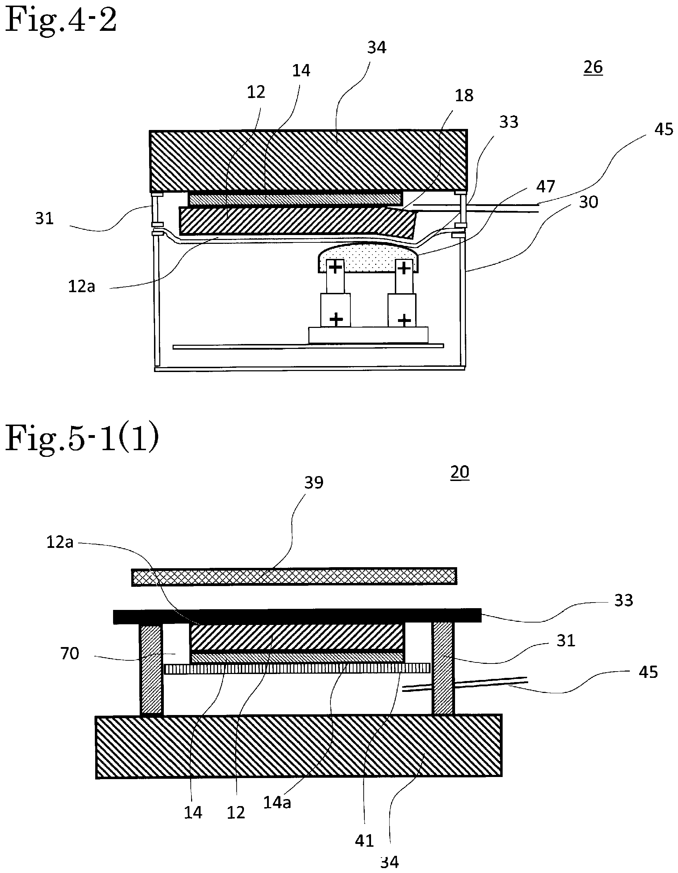

Fig. 4-2 is a schematic cross-sectional view of a releasing device different from the releasing device of Fig. 4-1 according to the third embodiment, immediately before releasing.

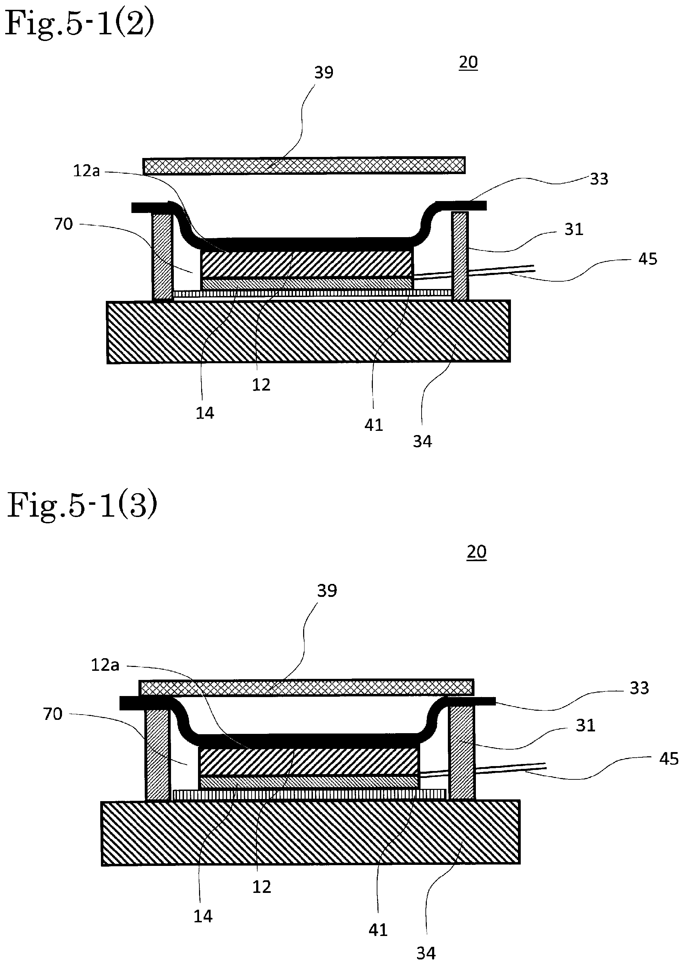

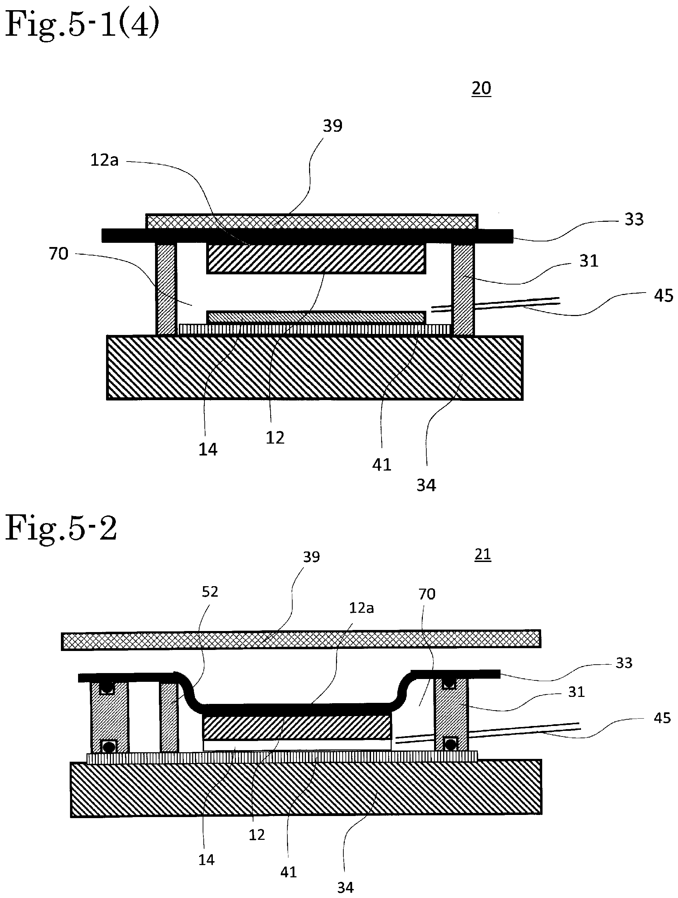

Fig. 5-1(1) is a schematic cross-sectional view of a releasing device according to a fourth embodiment. Fig. 5-1(1) shows a state where the releasing device is in the middle of being set and a second polymer film is installed on a partition wall.

Fig. 5-1(2) is a schematic cross-sectional view of the releasing device according to the fourth embodiment. Fig. 5-1(2) shows a state where the releasing device is in the middle of being set and a laminated body is fixed to a vacuum adsorption plate.

Fig. 5-1(3) is a schematic cross-sectional view of the releasing device according to the fourth embodiment. Fig. 5-1(3) shows a state where setting is completed.

Fig. 5-1(4) is a schematic cross-sectional view of the releasing device according to the fourth embodiment. Fig.

5-1(4) shows a state where releasing is completed.

Fig. 5-2 is a schematic cross-sectional view of a releasing device different from the releasing device of Fig. 5-1 according to the fourth embodiment. Fig. 5-2 shows a state where the releasing device is in the middle of being set.

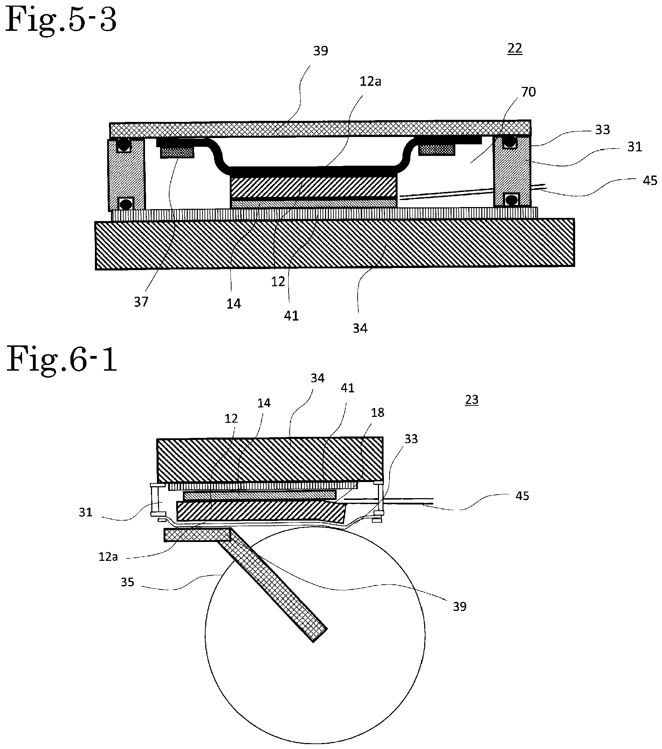

Fig. 5-3 is a schematic cross-sectional view of a releasing device different from the releasing devices of Figs. 5-1 and 5-2 according to the fourth embodiment, immediately before a releasing operation.

Fig. 6-1 is a schematic cross-sectional view of a releasing device according to a fifth embodiment. Fig. 6-1 is a schematic cross-sectional view of the releasing device immediately before releasing.

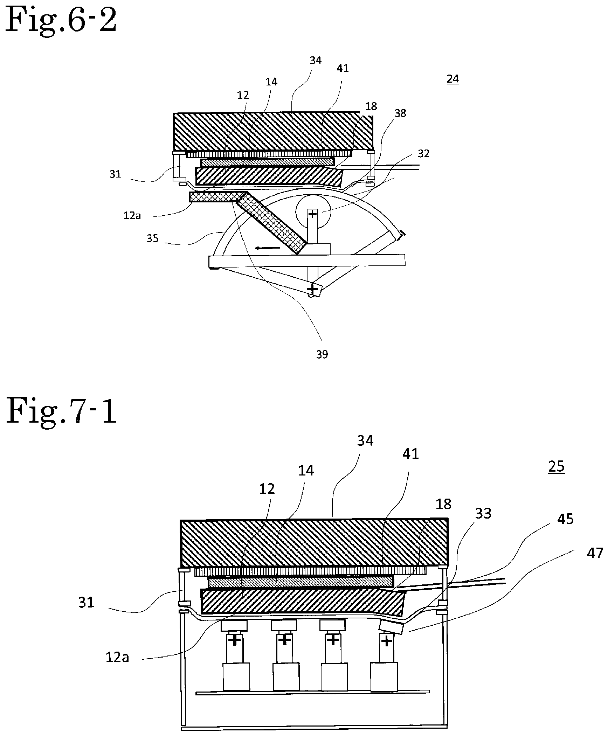

Fig. 6-2 is a schematic cross-sectional view of a releasing device different from the releasing device of Fig. 6-1 according to the fifth embodiment. Fig. 6-2 is a schematic cross-sectional view of the releasing device immediately before releasing.

Fig. 7-1 is a schematic cross-sectional view of a releasing device according to a sixth embodiment immediately before releasing.

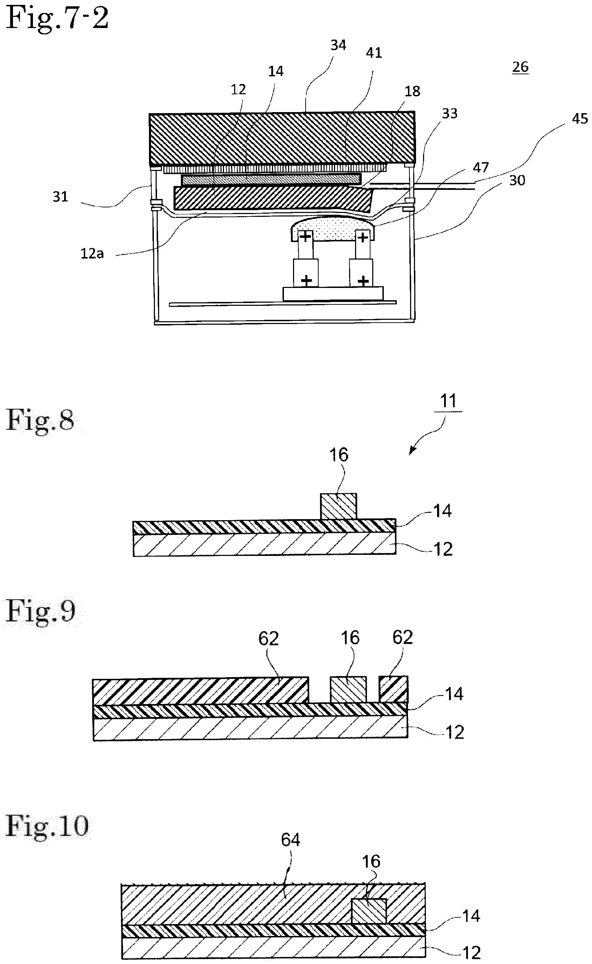

Fig. 7-2 is a schematic cross-sectional view of a releasing device different from the releasing device of Fig. 7-1 according to the sixth embodiment, immediately before releasing.

Fig. 8 is a schematic cross-sectional view illustrating an example of a laminated body equipped with a functional element.

Fig. 9 is a schematic cross-sectional view illustrating a state where a spacer is provided on a first polymer film of the laminated body equipped with a functional element.

Fig. 10 is a schematic cross-sectional view illustrating a state where an embedding vacuum chuck is disposed on the first polymer film of the laminated body equipped with a functional element and a functional element is embedded.

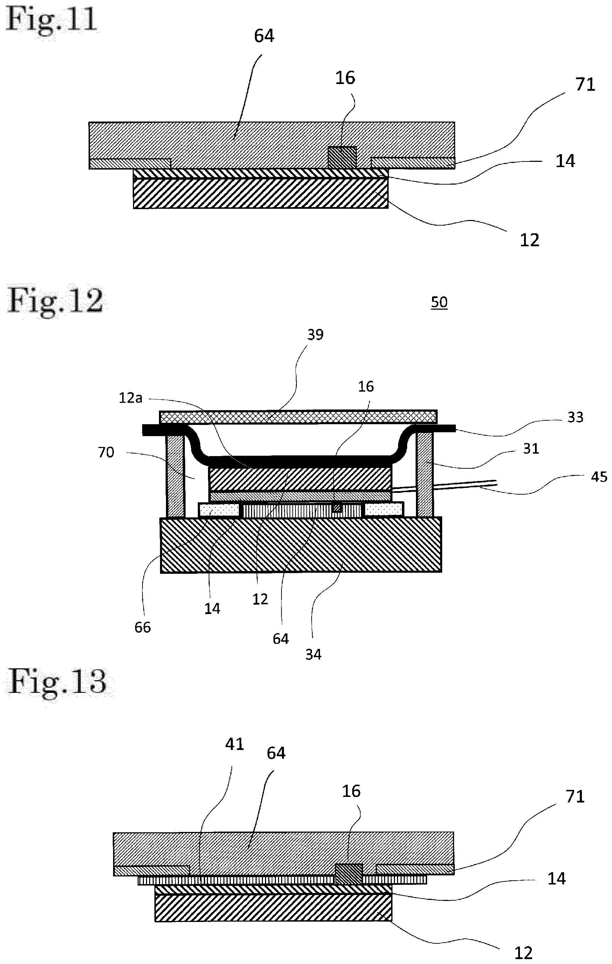

Fig. 11 is a schematic cross-sectional view illustrating a state where an embedding vacuum chuck is disposed on the first polymer film of the laminated body equipped with a functional element and a functional element is embedded. Herein, this is an example in which an adhesive member is disposed on an outer periphery of the laminated body.

Fig. 12 is another schematic cross-sectional view illustrating the releasing device according to the first embodiment in which an embedding vacuum chuck is disposed on a first polymer film of a laminated body equipped with a functional element and a functional element is embedded.

Fig. 13 is a schematic cross-sectional view of the fourth embodiment illustrating a state where an embedding vacuum chuck is disposed on the first polymer film of the laminated body equipped with a functional element and the functional element is embedded. Herein, an example in which a third polymer film is attached to an outer periphery of the first polymer film and the third polymer film is in close contact with an adhesive member disposed on an outer periphery of the laminated body is shown.

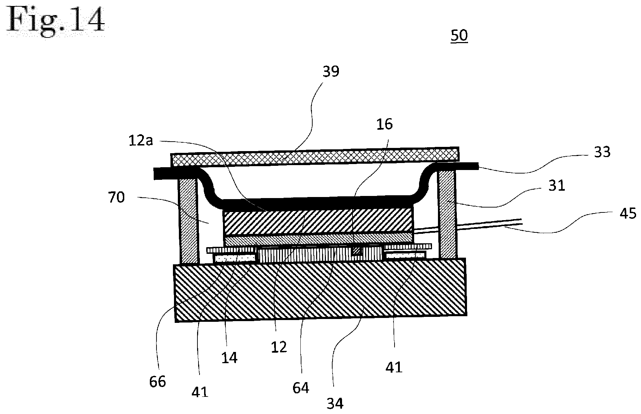

Fig. 14 is another schematic cross-sectional view illustrating the releasing device according to the fourth embodiment in which an embedding vacuum chuck is disposed on a first polymer film of a laminated body equipped with a functional element and a functional element is embedded. A third polymer film is attached to an outer periphery of the first polymer film and the third polymer film is in close contact with an adhesive member disposed on an outer periphery of the laminated body.

MODE FOR CARRYING OUT THE INVENTION

Hereinafter, embodiments of the present invention will be described. Hereinafter, a first polymer film releasing method will be described, and in the description, a method for manufacturing an electronic device and a releasing device will also be described.

[Polymer film releasing method]

A polymer film releasing method according to the present embodiment includes the following steps A, B1, and C or includes the following steps A, B2, and C. Hereinafter, the step B1 and the step B2 may be collectively referred to as a step B.

That is, the polymer film releasing method includes:

a step A of preparing a laminated body in which a first polymer film on which an electronic device is formed and an inorganic substrate are in close contact with each other;
a step B1 of fixing the laminated body to a vacuum adsorption plate such that a surface of the first polymer film of the laminated body is installed to be in contact with the vacuum adsorption plate, providing a partition wall on a side surface of the laminated body, and laminating a second polymer film, which is larger than the inorganic substrate, on a surface of the inorganic substrate of the laminated body to provide a sealed space formed by the vacuum adsorption plate, the second polymer film, and the partition wall; and
a step C of injecting a gas between the first polymer film and the inorganic substrate of the laminated body by a nozzle and applying a pressure to provide a releasing portion and release the first polymer film while keeping the first polymer film substantially flat.

Alternatively, the polymer film releasing method includes:

a step A of preparing a laminated body in which a first polymer film on which an electronic device is formed and an inorganic substrate are in close contact with each other;
a step B2 of laminating a third polymer film, which is larger than the first polymer film, on a surface of the first polymer film of the laminated body, fixing the laminated body to a vacuum adsorption plate such that the third polymer film is installed to be in contact with the vacuum adsorption plate, providing a partition wall on a side surface of the laminated body, and laminating a second polymer film, which is larger than the inorganic substrate, on a surface of the inorganic substrate of the laminated body to provide a sealed space formed by the second polymer film, the third polymer film, and the partition wall; and
a step C of injecting a gas between the first polymer film and the inorganic substrate of the laminated body by a nozzle and applying a pressure to provide a releasing portion and release the first polymer film while keeping the first polymer film substantially flat.

However, the step B also includes a case where some operation is performed as a step B of forming a releasing trigger portion between the first polymer film and the inorganic substrate at an end of the laminated body or no special operation is performed.
Since an object to be released in the present invention is the first polymer film, the first polymer film may be simply referred to as "polymer film".

<Step A>

In the polymer film releasing method according to the present embodiment, first, a laminated body in which a first polymer film on which an electronic device is formed and an inorganic substrate are in close contact with each other is prepared (step A). It is preferable that a laminated body in which a first polymer film and an inorganic substrate are in close contact with each other is prepared in advance, and an electronic device is formed on the polymer film. Fig. 1 is a schematic cross-sectional view illustrating an example of a laminated body. As illustrated in Fig. 1, a laminated body 10 includes an inorganic substrate 12 and a polymer film 14. The inorganic substrate 12 and the polymer film 14 are in close contact with each other. The electronic device is formed on a non-adhesive surface 14a, which is not in close contact with the inorganic substrate 12, of the polymer film. In Fig. 1, the electronic device is omitted. The inorganic substrate 12 and the polymer film 14 may be in close contact with each other via a silane coupling agent layer, an adhesive layer, or an easily releasable layer (not illustrated). In Fig. 1, the inorganic substrate 12 and the polymer film 14 have different thicknesses but are written in the same size. The sizes of the polymer film 14 and the inorganic substrate 12 are different, and the polymer film 14 may be larger or smaller than the inorganic substrate 12. Since a laminated body in which the polymer film 14 is smaller than the inorganic substrate 12 is easy to produce, the sizes of the polymer film 14 and the inorganic substrate 12 may be different as described above. In order to facilitate releasing, after the step A, glass of an outer periphery may be cleaved and removed from the laminated body in which the polymer film 14 and the inorganic substrate 12 are in close contact with each other, so that the polymer film 14 may be larger than the inorganic substrate 12. Although not illustrated, a protective film may be attached to the polymer film 14. The protective film size and the polymer film size may be the same, but the protective film may be small. The protective film is preferably applied before the step C described below.
The inorganic substrate 12 is only required to be a plate-shaped substrate that can be used as a substrate formed of an inorganic substance, and examples thereof include those mainly composed of glass plates, ceramic plates, semiconductor wafers, metals and the like and those in which these glass plates, ceramic plates, semiconductor wafers, and metals are laminated, those in which these are dispersed, and those in which fibers of these are contained as the composite of these.
The thickness of the inorganic substrate 12 is not particularly limited, but a thickness of 5 mm or less is preferable, a thickness of 1.2 mm or less is more preferable, and a thickness of 0.8 mm or less is still more preferable from the viewpoint of handleability. The lower limit of the thickness is not particularly limited, but is preferably 0.05 mm or more, more preferably 0.3 mm or more, and still more preferably 0.5 mm or more.
Examples of the first polymer film 14 include, but are not particularly limited to, films of polyimide-based resins (for example, aromatic polyimide resin and alicyclic polyimide resin) such as polyimide, polyamide-imide, polyetherimide, and fluorinated polyimide; copolymerized polyesters (for example, fully aromatic polyesters and semi-aromatic polyesters) such as polyethylene, polypropylene, polyethylene terephthalate, polybutylene terephthalate, and polyethylene-2,6-naphthalate; copolymerized (meth)acrylates represented by polymethylmethacrylate; polycarbonates; polyamides;

polysulfones; polyethersulfones; polyetherketones; cellulose acetates; cellulose nitrates; aromatic polyamides; polyvinyl chloride; polyphenols; polyarylates; polyphenylene sulfides; polyphenylene oxides; and polystyrenes.

The thickness of the first polymer film 14 is not particularly limited, but is preferably 250 $\mu$m or less, more preferably 100 $\mu$m or less, and still more preferably 50 $\mu$m or less from the viewpoint of handleability. The lower limit of the thickness is not particularly limited, but is preferably 3 $\mu$m or more, more preferably 5 $\mu$m or more, still more preferably 10 $\mu$m or more.

The surface, which is in contact with the inorganic substrate 12, of the first polymer film 14 is preferably subjected to a surface treatment. By performing the surface treatment, the peeling strength of the first polymer film is increased. The surface treatment is not particularly limited, but examples thereof include a plasma treatment and a UV/O$_3$ treatment, and a plasma treatment is preferable. The plasma treatment is preferably performed for 10 seconds or more, more preferably 30 minutes or more, and still more preferably 1 minute or more using a vacuum plasma treatment apparatus, for example. The plasma treatment is preferably performed for 30 minutes or less, more preferably 10 minutes or less, and still more preferably 5 minutes or less.

A second polymer film 33 and a third polymer film 41 are films larger than the first polymer film 14. The area of the second polymer film 33 is preferably 1.1 times or more, more preferably 1.5 times or more, and still more preferably 2 times or more the area of the first polymer film 14. The area of the second polymer film 33 is preferably 10 times or less, more preferably 8 times or less, still more preferably 5 times or less. Within the above range, a sealed space 70 described below can be easily produced. The shape of the second polymer film 33 may be a shape covering the entire surface of the inorganic substrate 12, or a shape in which a region of a center portion of the inorganic substrate 12 is hollowed out. The shape of the third polymer film 41 may be a shape covering the entire surface of the first polymer film 14, or a shape in which a region of a center portion of the first polymer film 14 is hollowed out.

The second polymer film 33 and the third polymer film 41 are not particularly limited as long as they have airtightness and strength enough to maintain a pressure difference generated at the time of releasing the first polymer film 14. Excellent gas barrier properties are not particularly required, and there is no problem as long as oxygen permeability is 10000 cc/m$^2$·hr·atm·25 $\mu$m (25°C, 50% RH) or less. If there is a slight elasticity, the second polymer film 33 and the third polymer film 41 are easy to follow the movement at the time of releasing and suitable. Examples of the material for the second polymer film 33 include, but are not particularly limited to, films of polyolefins such as polyethylene and polypropylene; copolymerized polyesters (for example, fully aromatic polyesters and semi-aromatic polyesters) such as polyethylene terephthalate, polybutylene terephthalate, and polyethylene-2,6-naphthalate; copolymerized (meth)acrylates represented by polymethylmethacrylate; polycarbonates; polyamides; polysulfones; polyethersulfones; polyetherketones; cellulose acetates; cellulose nitrates; aromatic polyamides; polyvinyl chloride; polyphenols; polyarylates; polyphenylene sulfides; polyphenylene oxides; and polystyrenes.

The second polymer film 33 and the third polymer film 41 may be the same as or different from the first polymer film 14. The second polymer film 33 and the third polymer film 41 are preferably relatively inexpensive and easily available as long as they satisfy the above physical properties.

The electronic device is a concept including a functional element, a thin film device, and a wiring. The electronic device is preferably a functional element having a thickness of 10 $\mu$m or more and 3 mm or less. The electronic device is more preferably a functional element having a thickness of 20 $\mu$m or more and 2 mm or less and more preferably a functional element having a thickness of 50 um or more and 1 mm or less. The functional element is an element having an electronic function such as a semiconductor chip. The thin film device is a device formed on the surface by a thin film production method such as sputtering or CVD and a patterning method. The thin film device refers to a thin film device in which the height difference of unevenness on the surface is less than 10 $\mu$m when the thin film device is formed on the first polymer film 14. Examples of a forming means include a means in which a thin film by CVD or sputtering, a wet film by plating or the like, a coating film, or the like is patterned to form a passive element such as an electric resistance or a capacitor, an active element such as a transistor or an FET, and a means in which these are electrically connected by an electric circuit. The wiring is mainly for electrical connection by a patterned metal layer, and connects a functional element and a thin film device.

A vacuum adsorption plate 34 (hereinafter, also referred to as a vacuum chuck) is a plate that fixes the laminated body 10 by vacuum adsorption, and fixes the laminated body 10 such that a surface of the first polymer film 14 of the laminated body 10 is in contact with the vacuum adsorption plate 34. Vacuum adsorption may be used alone, or a pressure-sensitive adhesive may be applied or attached to the surface of the vacuum adsorption plate 34 to adhesively fix the laminated body 10. For example, as illustrated in Figs. 12 and 14, a flexible support material 66 may be laminated on the surface of the vacuum adsorption plate 34, and fixed by both adhesion and vacuum adsorption.

The protective film is an adhesive film to be laminated on the surface (opposite side to the inorganic substrate 12) of the first polymer film 14, and is a film for protecting an electronic device including a functional element, a thin film device, and a wiring produced on the surface of the first polymer film 14. However, the third polymer film 41 may also serve as a protective film.

The protective film is preferably laminated on an outer periphery of the first polymer film 14 so as not to contact an electronic device formed on the first polymer film 14. The protective film preferably has adhesion enough to hold the first polymer film 14. The material for the protective film may be the same as or different from those for the first polymer film 14, the second polymer film 33, and the third polymer film 41.

A restriction plate 39 is a plate that is installed on a side of the second polymer film 33 opposite to the inorganic substrate 12 and restricts deformation of the inorganic substrate 12. The restriction plate 39 preferably has a function of restricting displacement of the inorganic substrate 12 due to a pressure difference of a gas, rather than displacing the inorganic substrate by vacuum adsorption, a mechanical gripping mechanism, attachment, or adhesion. The shape of the restriction plate 39 is not particularly limited, and examples thereof include a square, a rectangle, and a circle. The restriction plate 39 is preferably installed at a distance of 0.5 mm or more and 5 mm or less from the second polymer film 33. The distance is more preferably 1 mm or more and 4 mm or less.

Although not illustrated, in order to protect the thin film device, it is also preferable that only the main part or the entire surface is covered with a protective film with an adhesive layer or the like.

The silane coupling agent layer has an action of being physically or chemically interposed between the inorganic substrate 12 and the first polymer film 14 and bringing the inorganic substrate and the first polymer film into close contact with each other.

The silane coupling agent used in the present embodiment is not particularly limited, but preferably contains a coupling agent having an amino group. Preferred specific examples of the silane coupling agent include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl N-(1,3-dimethyl-butylidene)propylamine, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, vinyltrichlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-phenyl-3-aminopropyltrimethoxysilane, N-(vinylbenzyl)-2-aminoethyl-3-aminopropyltrimethoxysilane hydrochloride, 3-ureidopropyltriethoxysilane, 3-chloropropyltrimethoxysilane, 3-mercaptopropylmethyldimethoxysilane, 3-mercaptopropyltrimethoxysilane, bis(triethoxysilylpropyl)tetrasulfide, 3-isocyanatepropyltriethoxysilane, tris-(3-trimethoxysilylpropyl)isocyanurate, chloromethylphenetyltrimethoxysilane, chloromethyltrimethoxysilane, aminophenyltrimethoxysilane, aminophenethyltrimethoxysilane, and aminophenylaminomethylphenethyltrimethoxysilane.

As the silane coupling agent, in addition to the above, n-propyltrimethoxysilane, butyltrichlorosilane, 2-cyanoethyltriethoxysilane, cyclohexyltrichlorosilane, decyltrichlorosilane, diacetoxydimethylsilane, diethoxydimethylsilane, dimethoxydimethylsilane, dimethoxydiphenylsilane, dimethoxymethylphenylsilane, dodecyltrichlorosilane, dodecyltrimethoxysilane, ethyltrichlorosilane, hexyltrimethoxysilane, octadecyltriethoxysilane, octadecyltrimethoxysilane, n-octyltrichlorosilane, n-octyltriethoxysilane, n-octyltrimethoxysilane, triethoxyethylsilane, triethoxymethylsilane, trimethoxymethylsilane, trimethoxyphenylsilane, pentyltriethoxysilane, pentyltrichlorosilane, triacetoxymethylsilane, trichlorohexylsilane, trichloromethylsilane, trichlorooctadecylsilane, trichloropropylsilane, trichlorotetradecylsilane, trimethoxypropylsilane, allyltrichlorosilane, allyltriethoxysilane, allyltrimethoxysilane, diethoxymethylvinylsilane, dimethoxymethylvinylsilane, trichlorovinylsilane, triethoxyvinylsilane, vinyltris(2-methoxyethoxy)silane, trichloro-2-cyanoethylsilane, diethoxy(3-glycidyloxypropyl)methylsilane, 3-glycidyloxypropyl(dimethoxy)methylsilane, 3-glycidyloxypropyltrimethoxysilane, and the like may also be used.

Among the silane coupling agents, silane coupling agents having one silicon atom in one molecule are particularly preferable, and examples thereof include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, aminophenyltrimethoxysilane, aminophenetyltrimethoxysilane, and aminophenylaminomethylphenetyltrimethoxysilane. When particularly high heat resistance is required in the process, a silane coupling agent, in which an aromatic group links Si and an amino group to each other via, is desirable.

As the coupling agent, in addition to the above, 1-mercapto-2-propanol, methyl 3-mercaptopropionate, 3-mercapto-2-butanol, butyl 3-mercaptopropionate, 3-(dimethoxymethylsilyl)-1-propanethiol, 4-(6-mercaptohexaroyl)benzyl alcohol, 11-amino-1-undecenethiol, 11-mercaptoundecylphosphonic acid, 11-mercaptoundecyltrifluoroacetic acid, 2,2'-(ethylenedioxy)diethanethiol, 11-mercaptoundecytri(ethylene glycol), (1-mercaptoundec-11-yl)tetra(ethylene glycol), 1-(methylcarboxy)undec-11-yl)hexa(ethylene glycol), hydroxyundecyl disulfide, carboxyundecyl disulfide, hydroxyhexadodecyl disulfide, carboxyhexadecyl disulfide, tetrakis(2-ethylhexyloxy)titanium, titanium dioctyloxy bis(octylene glycolate), zirconium tributoxy monoacetylacetonate, zirconium monobutoxy acetylacetonate bis(ethylacetoacetate), zirconium tributoxy monostearate, acetoalkoxy aluminum diisopropylate, 3-glycidyloxypropyltrimethoxysilane, 2,3-butanedithiol, 1-butanethiol, 2-butanethiol, cyclohexanethiol, cyclopentanethiol, 1-decanethiol, 1-dodecanethiol, 2-ethylhexyl 3-mercaptopropionate, ethyl 3-mercaptopropionate, 1-heptanethiol, 1-hexadecanethiol, hexyl mercaptan, isoamyl mercaptan, isobutyl mercaptan, 3-mercaptopropionic acid, 3-methoxybutyl 3-mercaptopropionate, 2-methyl-1-butanethiol, 1-octadecanethiol, 1-octanethiol, 1-pentadecanethiol, 1-pentanethiol, 1-propanethiol, 1-tetradecanethiol, 1-undecanethiol, 1-(12-mercaptododecyl)imidazole, 1-(11-mercaptoundecyl)imidazole, 1-(10-mercaptodecyl)imidazole, 1-(16-mercaptohexadecyl)imidazole, 1-(17-mercaptoheptadecyl)imidazole, 1-(15-mercapto)dodecanoic acid, 1-(11-mercapto)undecanoic acid, 1-(10-mercapto)decanoic acid, and the like may also be used.

As the method for applying a silane coupling agent (method for forming a silane coupling agent layer), a method in which a silane coupling agent solution is applied to the inorganic substrate 12, a vapor-deposition method, and the like can be used. The silane coupling agent layer may be formed on the surface of the first polymer film 14.

The film thickness of the silane coupling agent layer is extremely thinner compared to those of the inorganic substrate 12, the first polymer film 14, and the like, is a thickness negligible from the viewpoint of mechanical design, and is only required to be minimum a thickness in the monomolecular layer order in principle.

After the silane coupling agent is applied, the adhesive force of the laminated body can be developed by a step of bringing the inorganic substrate 12 and the first polymer film 14 into close contact with each other and a heating step. The adhering method is not particularly limited, and examples thereof include lamination and pressing. The adhering and the heating may be performed simultaneously or sequentially. The heating method is not particularly limited, but may be placing in an oven, heating lamination, heating press, or the like.

As a method for producing the laminated body 10 in which the first polymer film 14 and the inorganic substrate 12 are in close contact with each other, the inorganic substrate 12 and the first polymer film 14 may be separately produced and then brought into close contact with each other, and at this time, may be bonded using an easily releasable adhesive other than a known silane coupling agent, an adhesive sheet, a pressure-sensitive adhesive, or a pressure-sensitive adhesive sheet. At this time, the adhesive, the adhesive sheet, the pressure-sensitive adhesive, or the pressure-sensitive adhesive sheet may be attached first to the inorganic substrate 12 side, or may be attached first to the first polymer film 14 side. As another method for producing the laminated body 10 in which the first polymer film 14 and the inorganic substrate 12 are in close contact with each other, a varnish for forming the first polymer film 14 may be applied onto the inorganic substrate 12 and dried. At this time, in order to control the peeling strength between the inorganic substrate 12 and the first polymer film 14, a two-layer configuration of a known easily releasable varnish layer (easily releasable layer) and a main varnish layer (first polymer film 14) or a two-layer configuration of a main layer (first polymer film 14) and an inorganic thin film layer may be adopted.

<Step B>

Next, as a preliminary step for releasing, in a first embodiment, the sealed space 70 is provided by the vacuum adsorption plate 34 (hereinafter, also referred to as a vacuum chuck), the second polymer film 33, and a partition wall 31 (step B1). In a fourth embodiment, the sealed space 70 is provided by the second polymer film 33, the third polymer film 41, and the partition wall 31 (step B2). The partition wall 31 is provided on a side surface of the laminated body 10. As described above, in the first embodiment, the laminated body is fixed to the vacuum adsorption plate 34 such that the first polymer film 14 of the laminated body 10 is installed to be in contact with the vacuum adsorption plate 34. In the fourth embodiment, the laminated body is fixed to the vacuum adsorption plate 34 via the third polymer film such that the first polymer film 14 of the laminated body 10 is installed to be in contact with the vacuum adsorption plate 34. On the other hand, the second polymer film 33 is laminated on the surface of the inorganic substrate 12 of the laminated body 10. The laminated body 10 is preferably laminated near the center of the second polymer film 33. By laminating the laminated body 10 near the center, an end (a portion where the laminated body 10 is not laminated) of the second polymer film 33 can be easily bonded to the partition wall 31. The method of bonding the laminated body 10 and the second polymer film 33 to each other is not particularly limited, and examples thereof include a method of bonding the laminated body 10 and the second polymer film 33 to each other using a double-sided tape, a method of preparing a glue layer on the second polymer film 33 in advance and bonding them to each other using the glue layer, and a method of bonding the laminated body 10 and the second polymer film 33 to each other via an adhesive. In the step C, any method may be used as long as there is strong adhesion that does not release the first polymer film 14 when the first polymer film 14 is released. The bonding method can be realized by combining existing methods such as a pressure-sensitive method, heat curing, and photocuring. Combining with existing substrate cleaning is also effective for stabilizing the adhesive force. The partition wall 31 provided on the side surface of the laminated body 10 is preferably not in contact with the laminated body 10. In order to appropriately maintain the capacity of the sealed space 70, a distance between the side surface of the laminated body 10 and the partition wall 31 is preferably 1 mm or more, more preferably 5 mm or more, and still more preferably 10 mm or more. The distance is preferably 200 mm or less, more preferably 100 mm or less, still more preferably 50 mm or less. Within the above range, the sealed space 70 has an appropriate capacity, and the pressure does not leak to the outside even when a gas is injected from an air blow nozzle 45 (hereinafter, also referred to as the nozzle) and pressurized, so that the first polymer film 14 is easily released. That is, in the first embodiment, the sealed space 70 can be said to be a space in which the laminated body 10 is surrounded by the vacuum adsorption plate 34, the second polymer film 33, and the partition wall 31. In the fourth embodiment, the sealed space 70 can be said to be a space in which the laminated body 10 is surrounded by the second polymer film 33, the third polymer film 41, and the partition wall 31. Setting of the restriction plate 39 at a predetermined position and nozzle setting to the device are performed, and in some cases, the releasing portion 18 is formed between the polymer film 14 and the inorganic substrate 12 at the end of the laminated body 10.

With the presence of the second polymer film 33, a space for confining the air from the nozzle 45 can be simplified, so that it is not necessary to narrow the distance between the partition wall 31 and the inorganic substrate 12 to form a space for confining the air, and the degree of freedom of setting is increased while increasing the success rate of releasing.

In the fourth embodiment, with the presence of the third polymer film 41, it is easier to prevent vacuum leakage from the gap between the vacuum adsorption plate 34 and the first polymer film 14, and the holding force of the first polymer film 14 can be maintained. Thereby, it is easier to prevent the first polymer film 14 from being released from the vacuum adsorption plate 34 (third polymer film 41) when the inorganic substrate 12 is displaced (released).

The partition wall 31 is preferably formed of a flexible material. Specific examples of the material for the partition wall include rubber materials such as O-rings and packings, and elastomer materials. A mixed material of these may be used. A bellows or a cylinder may be used to replace flexibility with a machine.

In the step B, in the first embodiment, the restriction plate 39 is preferably installed on a side of the second polymer film 33 opposite to the inorganic substrate 12. The deformation of the inorganic substrate 12 after the first polymer film 14 is released can be restricted by installing the restriction plate 39. The restriction plate 39 is installed preferably at a distance of 0.5 mm or more and 5 mm or less and more preferably at a distance of 1 mm or more and 4 mm or less from the second polymer film 33. Within the above range, breakage of the inorganic substrate 12 after releasing can be prevented. In the second embodiment, the restriction plate 39 is preferably in contact with the inorganic substrate 12.

It is preferable to install the nozzle 45 for injecting a gas. The installation method of the nozzle 45 is not particularly limited as long as the pressure in the sealed space 70 does not leak. For example, the nozzle may be installed by forming a hole in the partition wall 31, or may be installed from a bonding gap between the partition wall 31 and the second polymer film 33. The tip of the nozzle 45 is preferably installed near a lamination surface (boundary surface) between the first polymer film 14 and the inorganic substrate 12. By installing the nozzle near the lamination surface (boundary surface), the first polymer film 14 is easily released.

It is preferable to provide the releasing portion 18 between the first polymer film 14 and the inorganic substrate 12 in advance. The releasing portion 18 is preferably a lamination surface (boundary surface) of the end of the laminated body 10. However, depending on the quality of the film end, releasing can be performed without specially forming the releasing portion 18. The method of providing the releasing portion 18 is not particularly limited, but a method in which the first polymer film 14 is stripped off from the end with tweezers and the like, a method in which a notch is made in the first polymer film 14, a pressure sensitive adhesive tape is pasted to one side of the notch portion, and then the first polymer film 14 is stripped off from the tape portion, a method in which one side of the notch portion of the first polymer film 14 is vacuum-adsorbed and then the first polymer film 14 is stripped off from that portion, and the like can be employed.

As the method for making a notch into the first polymer film 14, there are a method in which the first polymer film 14 is cut with a cutting tool such as a cutter, a method in which the first polymer film 14 is cut by scanning a laser and the laminated body 10 relative to each other, a method in which the first polymer film 14 is cut by scanning a water jet and the laminated body 10 relative to each other, a method in which the first polymer film 14 is cut while being notched a little to the glass layer by a dicing apparatus for a semiconductor chip, and the like, but the method is not particularly limited. For example, when the above-described methods are adopted, it is also possible to appropriately adopt a technique in which ultrasonic waves are superimposed on the cutting tool or a reciprocating motion, a vertical motion and the like are further added to improve the cutting performance. Although not illustrated, in order to maintain the released state so that the releasing portion 18 does not re-adhere, a film or sheet having no adhesion or no adhesiveness may be sandwiched between the releasing portions 18. A film or sheet having adhesion or adhesiveness on one side may be sandwiched between the releasing portions 18. A metal component (for example, a needle) may be sandwiched between the releasing portions 18.

<Step C>

The step C is a step of releasing the polymer film 14. In the first embodiment, in the step B1, the first polymer film 14 of the laminated body 10 is installed on the vacuum adsorption plate 34 and fixed by vacuum adsorption and/or adhesion, and the partition wall 31 is provided on a side surface of the laminated body 10. In the fourth embodiment, in the step B2, the first polymer film 14 of the laminated body 10 is installed via the third polymer film 41 on the vacuum adsorption plate 34 and fixed by vacuum adsorption and/or adhesion, and the partition wall 31 is provided on a side surface of the laminated body 10. From this state, a gas is preferably injected into the releasing portion 18 by the nozzle 45, and a pressure is applied to release the first polymer film 14 from the inorganic substrate 12 while keeping the first polymer film 14 substantially flat (step C).

The gas is not particularly limited, and air, nitrogen, helium, neon, argon, or the like can be used. These gases may be dried, but in the case of using a gas containing moisture, the film is easily released while static electricity is prevented.

By injecting a gas into the releasing portion 18, the pressure of the sealed space 70 is preferably made higher by 0.03 atm or more than the pressure in a space (outside the sealed space 70) on the side of the second polymer film 33 opposite to the laminated body 10. The pressure is more preferably higher by 0.1 atm or more, still more preferably higher by 0.2 atm or more, and particularly preferably higher by 0.3 atm or more in order to easily release the first polymer film 14. The pressure is preferably 10 atm or less and still more preferably 5 atm or less in order to prevent breakage of the inorganic substrate 12 after releasing.

The inorganic substrate 12 is preferably not largely curved. In the substantially flat surface, a minimum curvature radius of the curve is preferably 350 mm or more. The curvature radius is more preferably 500 mm or more and still more preferably 800 mm or more because the load of the inorganic substrate 12 can be reduced. The curvature radius is preferably 2000 mm or less and more preferably 1800 mm or less because the inorganic substrate 12 is greatly deformed in instantaneous deformation at the time of releasing.

Hereinafter, a specific example of the step C will be described.

[First embodiment]

In the first embodiment, since the inorganic substrate 12 and the vacuum adsorption plate 34 are substantially parallel and have a constant distance, deformation of the inorganic substrate 12 is restricted, but there is arbitrariness within this distance.

Figs. 2-1 to 2-3 are schematic cross-sectional views of the releasing device according to the first embodiment. Figs. 2-1(1) to 2-1(4) are schematic cross-sectional views of the releasing device according to the first embodiment. Figs. 2-1(1) and 2-1(2) are schematic cross-sectional views of the releasing device in the middle of being set, and Fig. 2-1(3) is a schematic cross-sectional view immediately before a gas is injected from the air blow nozzle 45. Fig. 2-1(4) is a schematic cross-sectional view after a gas is injected from the air blow nozzle 45 and releasing is performed. Figs. 2-2 and 2-3 are schematic cross-sectional views of the releasing devices each having a slight difference in structure. As illustrated in these drawings, releasing devices 20, 21, and 22 according to the first embodiment each include the partition wall 31, the second polymer film 33, the air blow nozzle 45, the vacuum chuck 34, and the restriction plate 39 which is a substantially flat plate. Depending on the device configuration, a second polymer film fixture 37 may be used.

The vacuum chuck 34 can adsorb and hold the laminated body 10, and releasing can be performed while the laminated body 10 is adsorbed. Since the first polymer film 14 side, that is, 14a of the laminated body 10 is adsorbed to the vacuum chuck 34, a pressure is applied from the air blow nozzle 45 to the releasing portion 18 between the first polymer film 14 and the inorganic substrate 12, so that the first polymer film 14 can be released from the inorganic substrate 12 while keeping the first polymer film 14 substantially flat. At the time of releasing, since the second polymer film 33 is laminated (attached) to the inorganic substrate 12 side, that is, a surface 12a of the laminated body 10 and a gas is supplied from the air blow nozzle 45 only to a space (sealed space 70) formed by the second polymer film 33, the partition wall 31, and the vacuum adsorption plate 34, the pressure of the gas is not supplied to a side (the outside of the sealed space 70) of the second polymer film 33 opposite to the inorganic substrate 12, and the pressure difference is maintained even when releasing of the first polymer film 14 and the inorganic substrate 12 is started. The air blow nozzle 45 corresponds to a pressure forming means of the present invention. Since the first polymer film 14 is adsorbed to the vacuum chuck 34 during the progress of releasing, the first polymer film 14 remains in a substantially flat surface, and the inorganic substrate 12 is displaced. At this time, when the inorganic substrate 12 can move completely freely, the inorganic substrate 12 is strongly bent, and the inorganic substrate may break or fly to an unexpected place. In order to prevent this, the restriction plate 39 is provided, but in the first embodiment, the inorganic substrate 12 and the restriction plate 39 are substantially parallel and have a constant distance. Therefore, deformation of the inorganic substrate 12 is restricted.

First, in the releasing devices 20, 21, and 22, after the second polymer film 33 is laminated (attached) to the inorganic substrate 12, the end of the second polymer film 33 is installed on the partition wall 31 (Fig. 2-1(1)). At this time, in the releasing device 21, the end of the second polymer film 33 is installed on the partition wall 31 and a porous flexible body 52. Next, the first polymer film 14 side of the laminated body 10 is adsorbed and fixed by the vacuum chuck 34 (Fig. 2-1(2)). Next, in the releasing devices 20, 21, and 22, the restriction plate 39 is pressed against the partition wall 31.

Next, in the releasing devices 20, 21, and 22, a gas is introduced from the air blow nozzle 45 penetrating the partition wall 31 so that the inorganic substrate 12 is displaced in a direction in which releasing (the releasing portion 18) between the inorganic substrate 12 and the first polymer film 14 spreads. The restriction plate 39 that is a substantially flat plate in parallel to the inorganic substrate 12 and is not in contact with the inorganic substrate 12 is installed on the inorganic substrate 12 side of the laminated body 10. Specifically, a notch (not illustrated) is formed in the vacuum chuck 34 below the first polymer film 14, and the air blow nozzle 45 is introduced from this end to facilitate deformation of the inorganic substrate 12.

Next, in the releasing devices 20, 21, and 22, it is preferable that the pressure on the non-adhesive surface side (the outside of the sealed space 70), which is not in close contact with the inorganic substrate 12, of the second polymer film 33 is set to the atmospheric pressure or lower than the pressure in the sealed space 70, and a gas is injected from the air blow nozzle 45 to advance releasing. The air blow nozzle 45 may be appropriately moved when the sample size is large. Although not illustrated in Figs. 2-1 to 2-3, for example, a vacuum chamber 30 can be used in order to make the pressure of the non-adhesive surface (the outside of the sealed space 70) low.

Next, the first polymer film 14 is released from the inorganic substrate 12 while keeping the entire first polymer film 14 substantially flat. At this time, since the first polymer film 14 is always held by the vacuum chuck 34, bending and deformation do not occur. The substantially flat surface not only a complete flat surface but also a surface having a flatness in JIS B 0621 (1984) of preferably 1000 $\mu$m or less, more preferably 500 $\mu$m or less, and still more preferably 100 $\mu$m or less. The deviation from the flat surface in a range of 1 mm$^2$ is preferably 10 $\mu$m or less, more preferably 3 um or less, and still more preferably 0.5 um or less.

The low pressure refers to a pressure lower than the pressure of the gas supplied from the air blow nozzle 45, and refers to a vacuum or depressurized state or a state opened to the atmosphere. When the pressure of the gas supplied from the air blow nozzle 45 is sufficiently high, a state where the slightly pressurized state pressure is controlled to be constant is also included in the low pressure.

The high pressure refers to a pressure generated in the releasing portion 18 by the pressure of the gas supplied from the air blow nozzle 45.

The partition wall 31 is provided on a side surface of the laminated body 10. The partition wall 31 is a wall for separating the inside and the outside of the sealed space 70, and prevents the pressure of the gas supplied from the air blow nozzle 45 from leaking to the outside of the sealed space 70. The side surface refers to a position parallel to a thickness direction of the laminated body 10. Since the partition wall 31 is present on the side surface of the laminated body 10, it is possible to approximately maintain the pressure difference between the inside and the outside of the sealed space 70 when a gas is injected into the releasing portion 18. Movement of the inorganic substrate 12 can be restricted only in a direction away from the first polymer film 14. The movement in the separating direction refers to a movement in which a distance between the inorganic substrate 12 and the first polymer film 14 increases in a direction substantially perpendicular to the plane of the first polymer film 14 at the time of releasing. The high pressure and the low pressure are separated by the presence of the partition wall.

[Second embodiment]

In a second embodiment, in order to prevent the inorganic substrate 12 from being bent at a predetermined curvature or more and being damaged, the inorganic substrate is pressed against the restriction plate 39 having a large curvature by gas pressure.

Figs. 3-1 and 3-2 are schematic cross-sectional views of modifications of a releasing device according to the second embodiment. As illustrated in Figs. 3-1 and 3-2, in releasing devices 23 and 24 according to the second embodiment, the restriction plate 35 having a predetermined curvature and the restriction plate 39 having a flat surface are installed while the restriction plate of the releasing devices 20, 21, and 22 described above is flat. Therefore, a gas having a pressure higher than the edge of the released inorganic substrate 12 may be introduced into the releasing portion 18 of the inorganic substrate 12. At this time, since the 12a side is held down by the restriction plates 35 and 39 via the second polymer film 33, a high-pressure gas does not enter. Therefore, releasing can be realized by maintaining the pressure difference between the releasing portion 18 and the non-adhesive surface 12a of the inorganic substrate. By allowing the inorganic substrate 12 to follow the restriction plate 35, it is mechanically restricted not to bend beyond the minimum curvature radius of the inorganic substrate 12.

[Third embodiment]

In a third embodiment, the inorganic substrate 12 is pressed against the restriction plate 39 by gas pressure, and the restriction plate 39 does not bend at a curvature equal to or less than a predetermined curvature by taking a motion to restrict the curvature.

Figs. 4-1 and 4-2 are schematic cross-sectional views of modifications of a releasing device according to the third embodiment. As illustrated in Figs. 4-1 and 4-2, in releasing devices 25 and 26 according to the third embodiment, a restriction plate 47 capable of changing positions and angles of the restriction plate according to progress of releasing is installed while the restriction plate of the releasing devices 20, 21, and 22 described above is flat and fixed. Therefore, a gas having a pressure higher than the edge of the released inorganic substrate 12 may be introduced into the releasing portion 18 of the inorganic substrate 12. At this time, since the 12a side is held down by the restriction plate 47 via the second film, a high-pressure gas does not enter. Therefore, releasing can be realized by maintaining the pressure difference between the releasing portion 18 and the non-adhesive surface 12a of the inorganic substrate. By allowing the inorganic substrate 12 to follow the restriction plate 47, the position and angle of the restriction plate 47 are controlled, so that it is restricted not to bend beyond the minimum curvature radius of the inorganic substrate 12 in a controlled manner.

[Fourth embodiment]

A fourth embodiment is an embodiment in which the third polymer film 41 is laminated on the surface of the first polymer film 14 of the laminated body 10 in the first embodiment. That is, the vacuum chuck 34 can adsorb and hold the laminated body 10 via the third polymer film 41, and releasing can be performed while the laminated body 10 is adsorbed.
Figs. 5-1 to 5-3 are schematic cross-sectional views of a releasing device according to the fourth embodiment, and Figs. 5-1(1) to 5-3 correspond to Figs. 2-1(1) to 2-3 in the first embodiment, respectively.

[Fifth embodiment]

A fifth embodiment is an embodiment in which the third polymer film 41 is laminated on the surface of the first polymer film 14 of the laminated body 10 in the second embodiment.
Figs. 6-1 and 6-2 are schematic cross-sectional views of modifications of a releasing device according to the fifth embodiment and correspond to Figs. 3-1 and 3-2 of the second embodiment.

[Sixth embodiment]

A sixth embodiment is an embodiment in which the third polymer film 41 is laminated on the surface of the first polymer film 14 of the laminated body 10 in the third embodiment.
Figs. 7-1 and 7-2 are schematic cross-sectional views of modifications of a releasing device according to the sixth embodiment and correspond to Figs. 4-1 and 4-2 of the third embodiment.
A case where the polymer film 14 equipped with a functional element 16 is released from the laminated body 11 equipped with a functional element will be described.
It is preferable that an embedding vacuum chuck and/or a spacer having a shape obtained by inverting a shape of the functional element is disposed on a side of the first polymer film 14 opposite to the inorganic substrate 12 before the step C.
Fig. 12 is a schematic cross-sectional view of the releasing device according to the first embodiment. Although the description is made with reference to this diagram, releasing can be performed in the laminated body 11 equipped with a functional element also in the second to sixth embodiments. As illustrated in Fig. 12, a releasing device 50 according to the first embodiment includes the partition wall 31, the second polymer film 33, the air blow nozzle 45, the vacuum chuck 34, an embedding vacuum chuck 64, and the restriction plate 39. In this diagram, the flexible support material 66 is also included. By providing the flexible support material 66, vacuum leakage is less likely to occur, which is more preferable.
The partition wall 31, the second polymer film 33, the air blow nozzle 45, and the vacuum chuck 34 have already been described in the section of the first embodiment, and thus the description thereof is omitted here.
The embedding vacuum chuck 64 is disposed on the vacuum chuck 34, and can hold the first polymer film 14 when the laminated body 11 equipped with a functional element is disposed on a surface opposite to the vacuum chuck 34. In Fig. 12, the embedding vacuum chuck 64 is in contact with the first polymer film 14, but may be positioned outside the first polymer film 14. The embedding vacuum chuck 64 is not particularly limited as long as it is porous and has flexibility, and examples thereof include a plastic sintered porous body, a metal porous sintered body, or a porous ceramic sintered body processed into a shape in which a functional element can be embedded.
In the releasing device 50, the first polymer film 14 side of the laminated body 11 equipped with a functional element is adsorbed by the embedding vacuum chuck 64 and positioned above the vacuum chuck 34. At this time, the functional element 16 of the laminated body 11 is positioned so as to be positioned in the opening of the embedding vacuum chuck 64.
Next, in the releasing device 50, the air blow nozzle 45 penetrates the partition wall 31. A gas is introduced from the air blow nozzle 45 so that the inorganic substrate 12 is displaced in a direction in which the releasing portion 18 between the inorganic substrate 12 and the first polymer film 14 spreads. The restriction plate 39 that is parallel to the inorganic substrate 12 and is not in contact with the inorganic substrate 12 is installed on the inorganic substrate 12 side of the laminated body 10. Specifically, a notch (not illustrated) is formed in the vacuum chuck 64 below the first polymer film 14 or the air blow nozzle 45 is introduced from this end to facilitate deformation of the first polymer film 14. It is preferable that the inorganic substrate 12 is not largely curved.

Next, the first polymer film 14 is released from the inorganic substrate 12 while keeping the entire first polymer film 14 substantially flat.

In the releasing device 50, since the first polymer film 14 is released from the inorganic substrate 12 by applying a pressure in a state where the functional element 16 is embedded in the embedding vacuum chuck 64, it is possible to suppress application of an excessive load to the first polymer film 14 at a position where the functional element 16 is positioned. Although an embedding member has some flexibility, the embedding member maintains a flat surface, and thus the first polymer film 14 is released while keeping the first polymer film 14 substantially flat. This also suppresses application of an excessive load to the first polymer film 14.

The air blow nozzle 45 corresponds to a pressure forming means of the present invention.

By providing the partition wall 31 so as to surround the nozzle 45 portion and fixing the second polymer film 33 to the inorganic substrate 12, the releasing portion 18 can be sealed, and the pressure difference between the inside and the outside of the sealed space 70 can be efficiently provided.

The polymer film 14 equipped with the functional element 16 released in the step C can be used as an electronic device, particularly, a flexible electronic device. That is, the method including the step A, the step B, and the step C is also a method for manufacturing an electronic device.

In the case of the first to third embodiments, a peeling strength F2 between the inorganic substrate 12 and the second polymer film 33 and a peeling strength F1 between the inorganic substrate 12 and the first polymer film 14 preferably have the following relationship:

$2 \times F1 < F2$. $2.5 \times F1 < F2$ is more preferable, and $3 \times F1 < F2$ is still more preferable. $10 \times F1 > F2$ is preferable, and $8 \times F1 > F2$ is more preferable. With the relationship, the first polymer film is easily released.

In the fourth to sixth embodiments, a peeling strength F2 between the inorganic substrate 12 and the second polymer film 33, a peeling strength F1 between the inorganic substrate 12 and the first polymer film 14, and a peeling strength F3 between the first polymer film 14 and the third polymer film 41 preferably have the following relationship:

$2 \times F1 < F2$ and $2 \times F1 < F3$. $2.5 \times F1 < F2$ and $2.5 \times F1 < F3$ are more preferable, and $3 \times F1 < F2$ and $3 \times F1 < F3$ are still more preferable. $10 \times F1 > F2$ and $10 \times F1 > F3$ are preferable, and $8 \times F1 > F2$ and $8 \times F1 > F3$ are more preferable. With the relationship, the first polymer film is easily released.

The embodiments of the present invention have been described above, but the present invention is not limited to the above-described examples, and design changes can be made as appropriate within the scope of satisfying the configuration of the present invention.

EXAMPLES

Peeling strength measurement method

An adhesive strength (180-degree peeling strength) between the inorganic substrate and the first polymer film (polyimide film) of the laminated body was measured according to a 180-degree peeling method described in JIS C 6471 (1995) under the following conditions.

Apparatus name: "Autograph (registered trademark) AG-IS" manufactured by SHIMADZU CORPORATION
Measured temperature: Room temperature
Peeling speed: 50 mm/min
Atmosphere: Air
Width of measured sample: 10 mm

Synthesis Example 1

The interior of a reaction vessel equipped with a nitrogen inlet tube, a thermometer, and a stirring rod was purged with nitrogen, and then 223 parts by mass of 5-amino-2-(p-aminophenyl)benzoxazole (DAMBO) and 4416 parts by mass of N,N-dimethylacetamide were added into the reaction vessel and completely dissolved. Next, a colloidal silica dispersion (product name: DMAc-ST-ZL manufactured by Nissan Chemical Corporation) was added to the solution together with 217 parts by mass of pyromellitic dianhydride (PMDA) so that the silica (lubricant) was 0.12% by mass with respect to the total amount of polymer solids in the polyamic acid solution, and the mixture was stirred at a reaction temperature of 25°C for 24 hours, thereby obtaining a viscous polyamic acid solution A.

Film Production Example 1

The polyamic acid solution A obtained above was applied onto the smooth surface (lubricant-free surface) of a long polyester film ("A-4100" manufactured by TOYOBO CO., LTD.) having a width of 1050 mm using a comma coater so that the final film thickness (film thickness after imidization) was about 5 $\mu$m, and then the polyamic acid solution A was applied thereonto using a slit die so that the final film thickness was 38 $\mu$m (including a thickness portion formed by the polyamic acid solution), dried at 105°C for 25 minutes, and released from the polyester film to obtain a self-supporting polyamic acid film having a width of 920 mm.

Next, the obtained self-supporting polyamic acid film was subjected to a heat treatment by raising the temperature stepwise in a temperature range of 180°C to 495°C with a pin tenter to be imidized. Specifically, the heat treatment was performed at 180°C for 5 minutes in the first stage, at 220°C for 5 minutes in the second stage, and at 495°C for 10 minutes in the third stage. Next, pin holding portions at both ends were dropped with slits to obtain a long polyimide film (1000 m winding) having a width of 850 mm. The thickness of the polyimide film actually obtained was 36 $\mu$m. The obtained polyimide film is used as a polyimide film 1.

Laminated Body Production Example 1

As the inorganic substrate, glass for liquid crystal (OA11 manufactured by Nippon Electric Glass Co., Ltd.) having a size of 370 mm × 470 mm and a thickness of 0.5 mm was used, and a silane coupling agent treatment was performed by a spin coating method.

Then, the glass was cut into a size of 360 mm × 460 mm, and temporarily laminated using a laminator (SE650nH manufactured by CLIMB PRODUCTS CO., LTD.) such that the plasma-treated surface of the polyimide film 1 subjected to the plasma treatment overlapped the silane-coupling agent-treated surface of the inorganic substrate. The plasma treatment was performed in a batch-type plasma apparatus for 2 minutes. The lamination conditions were an inorganic substrate side temperature of 100°C, a roll pressure at the time of lamination of 5 kg/cm$^2$, and a roll speed of 5 mm/sec. The polyimide film 1 after the temporary lamination was not peeled off by its own weight, but had adhesiveness to such an extent that it was easily peeled off when the film end was scratched. Thereafter, the obtained temporarily laminated substrate was placed in a clean oven, heated at 200°C for 30 minutes, and then allowed to cool to room temperature to obtain a polymer film laminated body. Thereafter, the polymer film laminated body was appropriately cut and used for the subsequent experiments. This laminated body was used as a laminated body sample 1.

Laminated Body Production Example 2

In Laminated Body Production Example 2, a laminated body was produced in the same manner as in Laminated Body Production Example 1, except that the plasma treatment time was set to 1/10 of that in Laminated Body Production Example 1. This laminated body was used as a laminated body sample 2.

Examples 1 to 5

A releasing experiment was performed using the 100 × 100 mm samples of the laminated body samples 1 and 2 produced in the laminated body production example. The distance between the glass upper surface and the restriction plate was set to 2.5 mm. The experiment was performed at an F1 (the peeling strength between the inorganic substrate and the first polymer film) of 2.1 N/cm in the laminated body sample 1 and of 0.13 N/cm in the laminated body sample 2. The experiment was performed using a tape with the F2 (the peeling strength between the inorganic substrate and the second polymer film) being 5.4 N/cm in the laminated body sample 1 and a tape with the F2 being 2.1 N/cm in the laminated body sample 2. A releasing experiment was performed at introduction pressures from the nozzle of 0.01 MPa, 0.02 MPa, 0.05 MPa, 0.10 MPa, and 0.15 MPa using a releasing device of Fig. 2-1 as the releasing device, using a PET film as the second polymer film. The results are shown in Table 1. ○ indicates a case where the entire surface could be released and the glass was not broken. △ indicates a case where the surface could be released but the glass was partially chipped. × indicates a case where the entire surface could not be released.

Examples 6 to 9

A releasing experiment was performed using the 100 × 100 mm samples of the laminated body samples 1 and 2 produced in the laminated body production example. A releasing device of Fig. 2-2 was used as the releasing device, and the introduction pressure from the nozzle was set to 0.1 MPa. The experiment was performed at an F1 (the peeling strength between the inorganic substrate and the first polymer film) of 2.1 N/cm in the laminated body sample 1 and of 0.13 N/cm in the laminated body sample 2. The experiment was performed using a tape with the F2 (the peeling strength between the inorganic substrate and the second polymer film) being 5.4 N/cm in the laminated body sample 1 and a tape with the F2 being 2.1 N/cm in the laminated body sample 2. A releasing experiment was performed while the distance between the glass upper surface and the restriction plate was changed to 0.5 mm, 1.0 mm, 3.0 mm, and 5.0 mm. The results are shown in Table 2. ○ indicates a case where the entire surface could be released and the glass was not broken. △ indicates a case where the surface could be released but the glass was partially chipped or the glass was broken. × indicates a case where the entire surface could not be released.

Examples 10 to 13

A releasing experiment was performed using the 100 × 100 mm samples of the laminated body samples 1 and 2 produced in the laminated body production example. Examples 10 to 12 are the laminated body sample 1, and Example 13 is the laminated body sample 2. The pressure applied to the nozzle at this time was 0.1 MPa, and the distance between the restriction plate and the glass was 2.5 mm. A releasing experiment was performed using a releasing device of Fig. 2-2 as the releasing device and different double-sided tapes for bonding the second polymer film and glass together while changing the peeling strength as shown in Table 3. The results are shown in Table 3. ○ indicates a case where the entire surface could be released and the glass was not broken. × indicates a case where the entire surface could not be released. △ indicates a case where the surface could be released but the second polymer film was partially released from the glass.

Examples 14 to 18

A releasing experiment was performed using the 100 × 100 mm samples of the laminated body samples 1 and 2 produced in the laminated body production example. The distance between the glass upper surface and the restriction plate was set to 2.5 mm. The experiment was performed at an F1 (the peeling strength between the inorganic substrate and the first polymer film) of 2.1 N/cm in the laminated body sample 1 and of 0.13 N/cm in the laminated body sample 2. The experiment was performed using a tape with each of the F2 (the peeling strength between the inorganic substrate and the second polymer film) and the F3 (the peeling strength between the first polymer film and the third polymer film) being 5.4 N/cm in the laminated body sample 1 and a tape with each of the F2 and the F3 being 2.1 N/cm in the laminated body sample 2. A releasing experiment was performed at introduction pressures from the nozzle of 0.01 MPa, 0.02 MPa, 0.05 MPa, 0.10 MPa, and 0.15 MPa using a releasing device of Fig. 5-1 as the releasing device, using PET films as the second polymer film and the third polymer film. The results are shown in Table 4. ○ indicates a case where the entire surface could be released and the glass was not broken. △ indicates a case where the surface could be released but the glass was partially chipped. × indicates a case where the entire surface could not be released.

Examples 19 to 22

A releasing experiment was performed using the 100 × 100 mm samples of the laminated body samples 1 and 2 produced in the laminated body production example. A releasing device of Fig. 5-2 was used as the releasing device, and the introduction pressure from the nozzle was set to 0.1 MPa. The experiment was performed at an F1 (the peeling strength between the inorganic substrate and the first polymer film) of 0.9 N/cm in the laminated body sample 1 and of 0.13 N/cm in the laminated body sample 2. The experiment was performed using a tape with each of the F2 (the peeling strength between the inorganic substrate and the second polymer film) and the F3 (the peeling strength between the first polymer film and the third polymer film) being 5.4 N/cm in the laminated body sample 1 and a tape with each of the F2 and the F3 being 2.1 N/cm in the laminated body sample 2. A releasing experiment was performed while the distance between the glass upper surface and the restriction plate was changed to 0.5 mm, 1.0 mm, 3.0 mm, and 5.0 mm. The results are shown in Table 5. ○ indicates a case where the entire surface could be released and the glass was not broken. △ indicates a case where the surface could be released but the glass was partially chipped or the glass was broken. × indicates a case where the entire surface could not be released.

Examples 23 to 26

A releasing experiment was performed using the 100 × 100 mm samples of the laminated body samples 1 and 2 produced in the laminated body production example. Examples 23 to 25 are the laminated body sample 1, and Example 26 is the laminated body sample 2. The pressure applied to the nozzle at this time was 0.1 MPa, and the distance between the restriction plate and the glass was 2.5 mm. A releasing experiment was performed using a releasing device of Fig. 5-2 as the releasing device and different double-sided tapes for bonding the second polymer film and glass together and the first polymer film and the third polymer film together while changing the peeling strength as shown in Table 6. The results are shown in Table 6. ○ indicates a case where the entire surface could be released and the glass was not broken. × indicates a case where the entire surface could not be released. △ indicates a case where the surface could be released but the second polymer film was partially released from the glass.

Comparative Examples 1 to 4

A releasing experiment was performed using the 100 × 100 mm samples of the laminated body samples 1 and 2 produced in the laminated body production example. The laminated bodies of Comparative Examples 1 and 2 were produced under the same conditions as in Example 12, and the laminated bodies of Comparative Examples 3 and 4 were produced under the same conditions as in Example 25. The pressure applied to the nozzle at this time was 0.1 MPa, and the distance between the restriction plate and the glass was 2.5 mm. The releasing device of Fig. 2-2 was used in Comparative Examples 1 and 2, and the releasing device of Fig. 5-2 was used in Comparative Examples 3 and 4. Comparative Example 1 is an example in which the second polymer film is not used (without the peeling strength of F2), Comparative Example 3 is an example in which the second and third polymer films are not used (without the peeling strength of F2), and Comparative Examples 2 and 4 are examples in which the partition wall is not used. The results are shown in Table 7. ○ indicates a case where the entire surface could be released and the glass was not broken. △ indicates a case where the surface could be released but the second polymer film was partially released from the glass. × indicates a case where the entire surface could not be released.

[Table 1]

|  | Feeding pressure (MPa) | Laminated body sample 1 | Laminated body sample 2 |
|---|---|---|---|
| Example 1 | 0.01 | △ | △ |
| Example 2 | 0.02 | ○ | ○ |
| Example 3 | 0.05 | ○ | ○ |
| Example 4 | 0.10 | ○ | ○ |
| Example 5 | 0.15 | ○ | △ |

[Table 2]

|  | Distance (mm) | Laminated body sample 1 | Laminated body sample 2 |
|---|---|---|---|
| Example 6 | 0.5 | ○ | △ |
| Example 7 | 1.0 | ○ | ○ |
| Example 8 | 3.0 | ○ | △ |
| Example 9 | 5.0 | △ | △ |

[Table 3]

|  | F1 (N/cm) | F2 (N/cm) | Laminated body sample |
|---|---|---|---|
| Example 10 | 0.13 | 3.00 | ○ |
| Example 11 | 0.13 | 2.10 | ○ |
| Example 12 | 0.13 | 0.31 | △ |
| Example 13 | 2.10 | 5.40 | ○ |

[Table 4]

|  | Feeding pressure (MPa) | Laminated body sample 1 | Laminated body sample 2 |
|---|---|---|---|
| Example 14 | 0.01 | △ | △ |
| Example 15 | 0.02 | ○ | ○ |

(continued)

|  | Feeding pressure (MPa) | Laminated body sample 1 | Laminated body sample 2 |
|---|---|---|---|
| Example 16 | 0.05 | ○ | ○ |
| Example 17 | 0.10 | ○ | ○ |
| Example 18 | 0.15 | ○ | △ |

[Table 5]

|  | Distance (mm) | Laminated body sample 1 | Laminated body sample 2 |
|---|---|---|---|
| Example 19 | 0.5 | ○ | △ |
| Example 20 | 1.0 | ○ | ○ |
| Example 21 | 3.0 | ○ | △ |
| Example 22 | 5.0 | △ | △ |

[Table 6]

|  | F1 (N/cm) | F2 (N/cm) | Laminated body sample |
|---|---|---|---|
| Example 23 | 0.13 | 3.00 | ○ |
| Example 24 | 0.13 | 2.10 | ○ |
| Example 25 | 0.13 | 0.31 | △ |
| Example 26 | 2.10 | 5.40 | ○ |

[Table 7]

|  | Configuration in device | Laminated body sample 1 | Laminated body sample 2 |
|---|---|---|---|
| Comparative Example 1 | No second film | × | × |
| Comparative Example 2 | No partition wall | × | × |
| Comparative Example 3 | No second polymer film and third polymer film | × | × |
| Comparative Example 4 | No partition wall | × | × |

INDUSTRIAL APPLICABILITY

As described above, the releasing method and the releasing technique of the present invention can be widely used in a scene of releasing the inorganic substrate and the first polymer film from each other in a manufacturing process of a display device, an electronic circuit device, a flexible printed wiring board, a tape automated bonding substrate, a chip-on-film package, a panel level package, a fan-out package, a fan-out panel level package, and the like manufactured through a laminated body including a first polymer film (polyimide film) and an inorganic substrate (glass substrate), and greatly contributes to the industrial world.

DESCRIPTION OF REFERENCE SIGNS

| | |
|---|---|
| 10 | Laminated body |
| 11 | Laminated body equipped with functional element |
| 12 | Inorganic substrate |
| 12a | Non-adhesive surface of inorganic substrate |
| 14 | First polymer film |
| 14a | Non-adhesive surface of first polymer film |
| 16 | Functional element |
| 18 | Releasing portion |
| 20, 21, 22, 23, 24, 25, 26, 50 | Releasing device |
| 31 | Partition wall |
| 33 | Second polymer film |
| 34 | Vacuum adsorption plate (vacuum chuck) |
| 35 | Restriction plate having large curvature radius |
| 37 | Second film fixture |
| 39 | Restriction plate |
| 41 | Third polymer film |
| 45 | Air blow nozzle (nozzle) |
| 47 | Position/angle-variable restriction plate |
| 52 | Porous flexible body |
| 62 | Spacer |
| 64 | Embedding vacuum chuck |
| 66 | Flexible support material |
| 70 | Sealed space |
| 71 | Adhesive member (adhesive protective film) |

**Claims**

1. A first polymer film releasing method comprising:

   a step A of preparing a laminated body in which a first polymer film on which an electronic device is formed and an inorganic substrate are in close contact with each other;
   a step B1 of fixing the laminated body to a vacuum adsorption plate such that a surface of the first polymer film of the laminated body is installed to be in contact with the vacuum adsorption plate, providing a partition wall on a side surface of the laminated body, and laminating a second polymer film, which is larger than the inorganic substrate, on a surface of the inorganic substrate of the laminated body to provide a sealed space formed by the vacuum adsorption plate, the second polymer film, and the partition wall; and
   a step C of providing a releasing portion between the first polymer film and the inorganic substrate of the laminated body and injecting a gas into the releasing portion to release the first polymer film while keeping the first polymer film substantially flat.

2. A first polymer film releasing method comprising:

   a step A of preparing a laminated body in which a first polymer film on which an electronic device is formed and an inorganic substrate are in close contact with each other;
   a step B2 of laminating a third polymer film, which is larger than the first polymer film, on a surface of the first polymer film of the laminated body, fixing the laminated body to a vacuum adsorption plate such that the third polymer film is installed to be in contact with the vacuum adsorption plate, providing a partition wall on a side surface of the laminated body, and laminating a second polymer film, which is larger than the inorganic substrate, on a surface of the inorganic substrate of the laminated body to provide a sealed space formed by the second polymer film, the third polymer film, and the partition wall; and
   a step C of providing a releasing portion between the first polymer film and the inorganic substrate of the laminated body and injecting a gas into the releasing portion to release the first polymer film while keeping the first polymer film substantially flat.

3. The first polymer film releasing method according to claim 1 or 2, wherein in the step C, a pressure inside the sealed space is increased to be higher by 0.02 atm or more than a pressure outside the sealed space by injecting a gas into the releasing portion.

4. The first polymer film releasing method according to any one of claims 1 to 3, wherein an adhesive protective film is laminated on a surface of the vacuum adsorption plate.

5. The first polymer film releasing method according to claim 4, wherein the fixing of the laminated body to the vacuum adsorption plate is vacuum adsorption or adhesion, or both vacuum adsorption and adhesion.

6. The first polymer film releasing method according to any one of claims 1 to 5, wherein the electronic device is a functional element having a thickness of 10 $\mu$m or more and 3 mm or less.

7. The first polymer film releasing method according to any one of claims 1 to 6, wherein an embedding vacuum chuck and/or a spacer having a shape obtained by inverting a shape of the functional element is disposed on a side of the first polymer film opposite to the inorganic substrate before the step C.

8. The first polymer film releasing method according to any one of claims 1 to 7, wherein a restriction plate, which restricts deformation of the inorganic substrate, is installed on a side of the second polymer film opposite to the inorganic substrate, and a distance between the restriction plate and the second polymer film is 0.5 mm or more and 5 mm or less.

9. The first polymer film releasing method according to any one of claims 1 to 7, wherein a restriction plate, which restricts deformation of the inorganic substrate, is installed on a side of the second polymer film opposite to the inorganic substrate, and the restriction plate and the second polymer film are in contact with each other.

10. The first polymer film releasing method according to any one of claims 1 to 9, wherein a peeling strength F2 between the inorganic substrate and the second polymer film and a peeling strength F1 between the inorganic substrate and the first polymer film have the following relationship:

$$2 \times F1 < F2.$$

11. The first polymer film releasing method according to any one of claims 2 to 9, wherein a peeling strength F2 between the inorganic substrate and the second polymer film, a peeling strength F3 between the first polymer film and the third polymer film, and a peeling strength F1 between the inorganic substrate and the first polymer film have the following relationship:

$$2 \times F1 < F2 \text{ and } 2 \times F1 < F3.$$

12. A method for manufacturing a polymer film equipped with an electronic device, comprising:

a step A of preparing a laminated body in which a first polymer film on which an electronic device is formed and an inorganic substrate are in close contact with each other;
a step B1 of fixing the laminated body to a vacuum adsorption plate such that a surface of the first polymer film of the laminated body is installed to be in contact with the vacuum adsorption plate, providing a partition wall on a side surface of the laminated body, and laminating a second polymer film, which is larger than the inorganic substrate, on a surface of the inorganic substrate of the laminated body to provide a sealed space formed by the vacuum adsorption plate, the second polymer film, and the partition wall; and
a step C of injecting a gas between the first polymer film and the inorganic substrate of the laminated body to release the first polymer film while keeping the first polymer film substantially flat.

13. A method for manufacturing a polymer film equipped with an electronic device, comprising:

a step A of preparing a laminated body in which a first polymer film on which an electronic device is formed and an inorganic substrate are in close contact with each other;

a step B2 of laminating a third polymer film, which is larger than the first polymer film, on a surface of the first polymer film of the laminated body, fixing the laminated body to a vacuum adsorption plate such that the third polymer film is installed to be in contact with the vacuum adsorption plate, providing a partition wall on a side surface of the laminated body, and laminating a second polymer film, which is larger than the inorganic substrate, on a surface of the inorganic substrate of the laminated body to provide a sealed space formed by the second polymer film, the third polymer film, and the partition wall; and

a step C of injecting a gas between the first polymer film and the inorganic substrate of the laminated body to release the first polymer film while keeping the first polymer film substantially flat.

14. A releasing device of peeling off a first polymer film from an inorganic substrate of a laminated body in which the first polymer film on which an electronic device is formed and the inorganic substrate are in close contact with each other, the releasing device comprising:

a pressure applying means for providing a pressure to a releasing portion between the first polymer film and the inorganic substrate, the releasing portion being provided at an end of the laminated body;

a means for installing a vacuum adsorption plate on a surface of the first polymer film of the laminated body, installing a partition wall on a side surface of the laminated body, and installing a second polymer film, which is larger than the inorganic substrate, on a surface of the inorganic substrate to provide a sealed space; and

a means for fixing the first polymer film substantially flatly during peeling.

15. A releasing device of peeling off a first polymer film from an inorganic substrate of a laminated body in which the first polymer film on which an electronic device is formed and the inorganic substrate are in close contact with each other, the releasing device comprising:

a pressure applying means for providing a pressure to a releasing portion between the first polymer film and the inorganic substrate, the releasing portion being provided at an end of the laminated body;

a means for installing a third polymer film, which is larger than the first polymer film, on a surface of the first polymer film of the laminated body, installing a partition wall on a side surface of the laminated body, and installing a second polymer film, which is larger than the inorganic substrate, on a surface of the inorganic substrate to provide a sealed space; and

a means for fixing the first polymer film substantially flatly during peeling.

# Fig.1

10

14a

14
10
12

12a

# Fig.2-1(1)

20

39

12a

33

70

31

45

14

12    14a

34

Fig.2-1(2)

20

39

12a

70

33

31

45

20

14

12

34

Fig.2-1(3)

20

39

12a

70

33

31

45

14

12

34

**Fig.2-1(4)**

**Fig.2-2**

## Fig.2-3

## Fig.3-1

# Fig.3-2

# Fig.4-1

Fig.4-2

Fig.5-1(1)

# Fig.5-1(2)

# Fig.5-1(3)

## Fig.5-1(4)

## Fig.5-2

## Fig.5-3

## Fig.6-1

## Fig.6-2

## Fig.7-1

# Fig.7-2

# Fig.8

# Fig.9

# Fig.10

Fig.11

Fig.12

Fig.13

Fig.14

## INTERNATIONAL SEARCH REPORT

| International application No. |
|---|
| **PCT/JP2022/014586** |

**A. CLASSIFICATION OF SUBJECT MATTER**

***B29C 69/00***(2006.01)i; ***B65H 41/00***(2006.01)i; ***H01L 21/02***(2006.01)i; ***H01L 21/683***(2006.01)i; ***H01L 21/301***(2006.01)i
FI: H01L21/68 N; B65H41/00 Z; H01L21/78 P; B29C69/00; H01L21/02 C

According to International Patent Classification (IPC) or to both national classification and IPC

**B. FIELDS SEARCHED**

Minimum documentation searched (classification system followed by classification symbols)

B29C69/00; B65H41/00; H01L21/02; H01L21/683; H01L21/301

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2021-027130 A (TOKYO ELECTRON LTD) 22 February 2021 (2021-02-22)<br>entire text, all drawings | 1-15 |
| A | JP 2013-504178 A (EV GROUP GMBH) 04 February 2013 (2013-02-04)<br>entire text, all drawings | 1-15 |
| A | JP 2015-202674 A (TOYOBO CO., LTD.) 16 November 2015 (2015-11-16)<br>entire text, all drawings | 1-15 |
| P, A | WO 2022/009451 A1 (TOYOBO CO., LTD.) 13 January 2022 (2022-01-13)<br>entire text, all drawings | 1-15 |

☐ Further documents are listed in the continuation of Box C.    ☑ See patent family annex.

| | |
|---|---|
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br><br>**27 May 2022** | Date of mailing of the international search report<br><br>**07 June 2022** |
| Name and mailing address of the ISA/JP<br><br>**Japan Patent Office (ISA/JP)**<br>**3-4-3 Kasumigaseki, Chiyoda-ku, Tokyo 100-8915**<br>**Japan** | Authorized officer<br><br><br><br><br>Telephone No. |

Form PCT/ISA/210 (second sheet) (January 2015)

**INTERNATIONAL SEARCH REPORT**
**Information on patent family members**

International application No.

**PCT/JP2022/014586**

| Patent document cited in search report | | | Publication date (day/month/year) | Patent family member(s) | | | Publication date (day/month/year) |
|---|---|---|---|---|---|---|---|
| JP | 2021-027130 | A | 22 February 2021 | (Family: none) | | | |
| JP | 2013-504178 | A | 04 February 2013 | US | 2012/0152465 | A1 | |
| | | | | entire text, all drawings | | | |
| | | | | EP | 2290679 | A1 | |
| | | | | CN | 102612740 | A | |
| | | | | KR | 10-2012-0067335 | A | |
| | | | | TW | 201133583 | A | |
| JP | 2015-202674 | A | 16 November 2015 | (Family: none) | | | |
| WO | 2022/009451 | A1 | 13 January 2022 | (Family: none) | | | |

Form PCT/ISA/210 (patent family annex) (January 2015)

**EP 4 331 816 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10125931 A
- JP 2018199163 A
- JP 2015038001 A